# EUROPEAN PATENT APPLICATION

(11) **EP 4 665 122 A1**
(43) Date of publication of application: **17.12.2025**
(21) Application number: 25181172.5
(22) Date of filing: 05.06.2025
(51) Int. Cl.: H10H 29/30, H10H 29/85

(54) **DISPLAY DEVICE**

(30) Priority: 11.06.2024 KR 20240075442
(71) Applicant: LG Display Co., Ltd., Seoul, 07336 (KR)
(72) Inventor: JUNG, Hyeyoung, 10845 Paju-si (KR); NA, Younsung, 10845 Paju-si (KR)
(74) Representative: Beal, James Michael

(57) **Abstract**

A display device may include a substrate, a pixel driving circuit on the substrate, a plurality of light-emitting elements over the pixel driving circuit and electrically connected to the pixel driving circuit, an optical layer including at least one layer covering the plurality of light-emitting elements, a black matrix including at least one layer disposed on the optical layer, a cover layer covering the black matrix, and a cover member disposed on the cover layer.

## Description

### BACKGROUND

### Field

This disclosure relates to a display device.

### Description of Related Art

Display devices are applied to various electronic devices such as televisions (TVs), mobile phones, laptops, and tablets.

The display devices may be classified into organic light-emitting display (OLED) devices having self-luminous properties, and liquid crystal display (LCD) devices requiring a separate light source.

Recently, display devices including a light-emitting diode (LED) (hereinafter, referred to as a "light-emitting element") are attracting attention as next-generation display devices. Since the light-emitting element is not configured with organic materials but inorganic materials, it can light up faster than the liquid crystal display device or the organic light-emitting display device, have excellent light-emitting efficiency, and display high-brightness images.

### SUMMARY

Generally, a display device may have a multilayer structure disposed therein, which includes a polarizing layer on a light-emitting element. The polarizing layer can prevent or reduce a phenomenon in which the light generated by an external light source enters the inside of the display panel and affects the light-emitting element or the like.

Only a portion of the light emitted from the internal light source to the outside is transmitted through the polarizing layer, which thus lowers the light extraction efficiency. As light extraction efficiency is lowered, the power consumption may increase to drive the display device while maintaining the quality of the display device.

Accordingly, the inventors of the present disclosure have, through various experiments and research, invented a display device with an increased light extraction efficiency by adjusting the range of transmittance of light emitted to the outside from a light source of a display panel.

An object to be accomplished according to an embodiment of the present disclosure is to provide a display device capable of improving the light extraction efficiency.

In addition, another object to be accomplished according to an embodiment of the present disclosure is to provide a display device capable of reducing the reflectivity.

The objects to be accomplished according to an embodiment of the present disclosure are not limited to the ones described above, and other objects and advantages of the present invention which are not mentioned can be understood from the following description, and will be more clearly understood from the embodiments of the present invention. Furthermore, it will be readily appreciated that the objects and advantages of the present disclosure can be realized by the means presented in the claims, and combinations thereof.

A display device according to an embodiment of the present disclosure may comprises: a substrate; a pixel driving circuit on the substrate; a plurality of light-emitting elements over the pixel driving circuit, the plurality of light-emitting elements electrically connected to the pixel driving circuit; an optical layer including at least one layer covering the plurality of light-emitting elements; a black matrix including at least one layer on the optical layer; a cover layer covering the black matrix; and a cover member on the cover layer.

In one embodiment, a display device comprises: a substrate; a pixel driving circuit on the substrate; a plurality of light-emitting elements over the pixel driving circuit, the plurality of light-emitting elements electrically connected to the pixel driving circuit; a black matrix having a plurality of openings that overlap the plurality of light-emitting elements; a reflectivity reduction layer in direct contact with an upper surface of the black matrix, the reflectivity reduction layer configured to reduce reflection of external light; a cover layer covering the black matrix and the reflectivity reduction layer; and a cover member on the cover layer.

According to an embodiment of the present disclosure, the reflection related to an external light source can be reduced by disposing a black matrix structured in multi layers having different optical densities.

Additionally, according to an embodiment of the present disclosure, the transmittance range can be adjusted by disposing the color filter to correspond to the light-emitting element.

Therefore, the polarizing layer can be omitted, thereby improving the light extraction efficiency. As a result, it is possible to provide a display device capable of being driven with low power and thus reducing power consumption.

In addition, according to an embodiment of the present disclosure, the polarizing layer constructed in a multilayer structure can be omitted, and thus it is possible to provide a display device having a thin thickness. Accordingly, it can be applied to variable display devices such as foldable display devices, flexible display devices, or bendable display devices, which need to be implemented in a thin thickness.

The present disclosure may have other effects besides the aforementioned ones, which are clearly recognizable to a person skilled in the art from the description below.

### BRIEF DESCRIPTION OF DRAWINGS

FIG. 1 is an exploded perspective view of a display device according to an embodiment of the present disclosure.
FIG. 2 is a plan view of a display device according to an embodiment of the present disclosure.
FIG. 3 is an enlarged view of a display device according to an embodiment of the present disclosure.
FIG. 4 is a diagram showing a circuit structure according to an embodiment of the present disclosure.
FIG. 5 is a plan view of a display device according to an embodiment of the present disclosure.
FIG. 6 is a plan view of a display device according to an embodiment of the present disclosure.
FIG. 7 is a plan view of a display device according to an embodiment of the present disclosure.
FIG. 8 is a cross-sectional view of a display device according to an embodiment of the present disclosure.
FIG. 9 is a cross-sectional view of a display device according to an embodiment of the present disclosure.
FIGS. 10 to 13 are views illustrating devices to which display devices according to embodiments of the present disclosure are applied.
FIG. 14 is a plan view showing an area where one pixel driving circuit of a plurality of pixel driving circuits is arranged.
FIG. 15 is a plan view of a display device having a black matrix disposed therein according to an embodiment of the present disclosure.
FIG. 16 is a cross-sectional view of a display device according to another embodiment of the present disclosure.
FIG. 17 is a plan view of a display device according to another embodiment of the present disclosure.
FIG. 18 is a cross-sectional view of a display device according to still another embodiment of the present disclosure.
FIG. 19 is a plan view of a display device according to still another embodiment of the present disclosure.

### DETAILED DESCRIPTION

Advantages and features of the present disclosure, and a method of achieving the advantages and features will become apparent when referring to the following embodiments described later in detail together with the accompanying drawings. However, the present disclosure is not limited to the embodiments as disclosed below, but may be embodied in various different forms. Thus, these embodiments are set forth only to make the present disclosure complete, and to completely inform the scope of the present disclosure to those of ordinary skill in the technical field to which the present disclosure belongs.

A shape, a size, a ratio, an angle, a number, etc. disclosed in the drawings for illustrating embodiments of the present disclosure are illustrative, and the present disclosure is not limited thereto. Throughout the detailed description, like reference numerals refer to like components. Further, in describing the present disclosure, if it is determined that a detailed description of a related known technology may unnecessarily obscure the gist of the present disclosure, the detailed description thereof will be omitted. It will be further understood that the terms "comprise", "comprising", "include", and "including" when used in the present disclosure, specify the presence of the stated features, integers, operations, elements, components and/or portions thereof, but do not preclude the presence or addition of one or more other features, integers, operations, elements, components, and/or portions thereof. When using an expression in a singular form to describe a component, it can include a meaning of a plural form unless explicitly stated to the contrary.

It should be noted that any component will be construed as including a tolerance or error range, even if there is no explicit description thereof.

In describing a position relationship between two elements, for example, when the position relationship is described using "on", "above", "below", and "next to", one or more other elements may be interposed between the two elements unless "just", "directly", or "close" is used.

In describing a temporal relationship, for example, when the temporal order is described as "after", "subsequent", "next", and "before", the case which is not continuous may also be included unless the term "just" or "directly" is used.

It will be understood that, although the terms "first", "second", etc. may be used herein to describe various elements, these elements should not be limited by these terms. These terms are only used to distinguish one element from another element. So, a first element referred to in the following description may represent a second element, without departing from the scope of the technical idea of the present disclosure. In describing components herein, terms such as first, second, A, B, (a), or (b) may be used. These terms are only intended to distinguish one component from another, and do not limit the nature, order, sequence, or number of the components.

When a component is described as being "connected to," "coupled to," "in contact with," or "attached to" another component, such component may be directly connected to, coupled to, contact with, or attached to the other component, and, however, it should be understood that they may be indirectly connected to, contact with, access to, or attached to each other with still another component interposed therebetween, unless explicitly stated to the contrary.

When a component or layer is described as "being in contact with," or "overlapping with" another component or layer, such component or layer may directly be in contact with or overlap with the other component or layer, and, however, it should be understood that they may also indirectly be in contact with or overlap with each other with still another component or layer interposed between, unless explicitly stated to the contrary.

The expression "at least one" should be understood to include any combination of one or more of the associated components. For example, the meaning of "at least one of the first, second, and third components" may include not only the first, second, or third component, but also any combination of two or more of the first, second, and third components.

The terms "first direction", "second direction", "third direction", "X-axis direction", "Y-axis direction", and "Z-axis direction" should not be interpreted as merely geometric relationships in which the relationship between them is perpendicular to each other, but may mean a wider directionality within the range in which the configuration of the present disclosure can act functionally.

The individual features of the various embodiments of the present disclosure may be coupled or combined with each other in part or in whole to be interconnected and operated in a variety of technical ways, and each embodiment may be implemented independently of each other or implemented together in an associative relationship.

Hereinafter, various embodiments of the present disclosure will be described in detail with reference to the accompanying drawings.

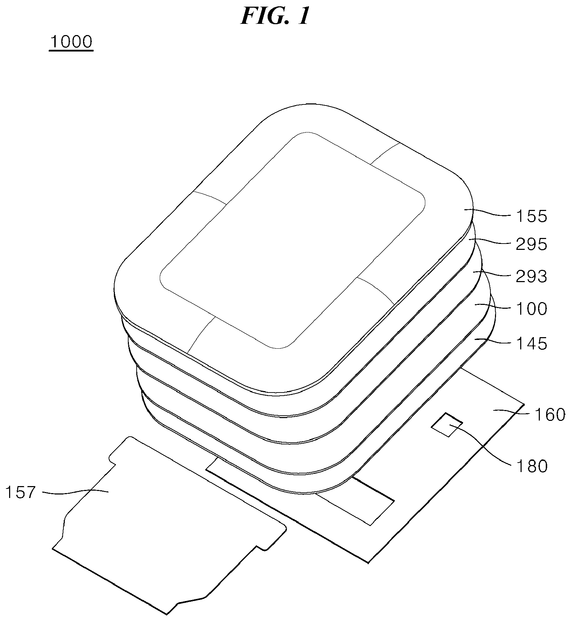

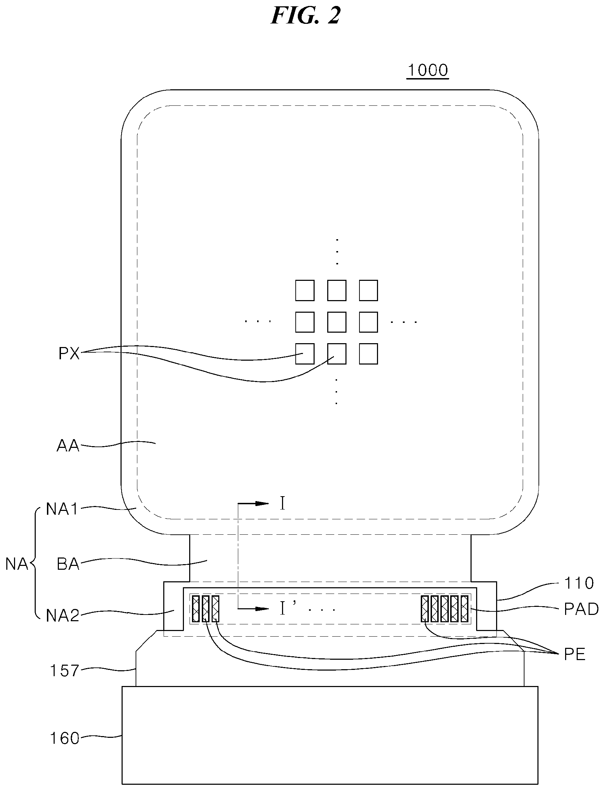

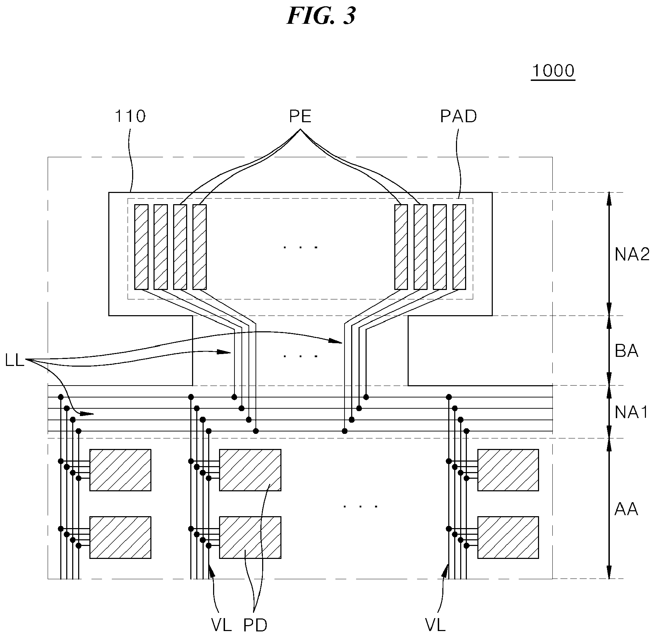

FIG. 1 is an exploded perspective view of a display device according to an embodiment of the present disclosure. FIG. 2 is a plan view of a display device according to an embodiment of the present disclosure. FIG. 3 is an enlarged view of a display device according to an embodiment of the present disclosure.

Referring to FIGS. 1 to 3, a display device 1000 according to an embodiment of the present disclosure may include a display panel 100, a polarizing layer 293, an adhesive layer 295, a cover member 155, a support substrate 145, a flexible circuit board 157, and a printed circuit board 160.

For example, the display device 1000 may include a substrate 110. The substrate 110 may be a member that supports other components of the display device 1000. The substrate 110 may be configured with an insulating material. For example, the substrate 110 may be configured with glass or resin. Alternatively, the substrate 110 may be configured with a material having flexibility. For example, the substrate 110 may be configured with a plastic material having flexibility, such as polyimide (PI). However, the embodiments of the present disclosure are not limited thereto.

The display panel 100 can implement information, video, and/or images to be provided to a user. For example, the display panel 100 may include a display area AA and a non-display area NA. For example, the substrate 110 may include the display area AA and the non-display area NA. The description for the display area AA and non-display area NA are not limited to the substrate 110, but may be applicable throughout the display device 1000.

The display area AA may be an area where an image is displayed. The display area AA may include a plurality of pixels PX. Each of the plurality of pixels PX may be constituted with a plurality of sub-pixels. At each of the plurality of sub-pixels a plurality of light-emitting elements may be disposed. The plurality of light-emitting elements may be configured differently depending on the kinds of display device 1000. For example, in a case where the display device 1000 is an inorganic light-emitting display device, the light-emitting element may be an LED (Light-emitting Diode), a Micro LED (Micro Light-emitting Diode), or a Mini LED (Mini Light-emitting Diode), but the embodiments of the present disclosure are not limited thereto.

The non-display area NA may be an area where an image is not displayed. In the non-display area NA, various wirings and circuits for driving a plurality of pixels PX in the display area AA may be disposed. For example, in the non-display area NA, there may be disposed a pad part PAD on which various wirings and driving circuits may be mounted and to which integrated circuits and printed circuits are connected, but the embodiments of the present disclosure are not limited thereto.

For example, the driving circuit may be a data driving circuit and/or a gate driving circuit, but the embodiments of the present disclosure are not limited thereto. In the non-display area NA, there may be disposed wirings through which control signals for controlling the driving circuits are supplied. For example, the control signal may include various timing signals including synchronization signals, an input data enable signal, and a clock signal, but the embodiments of the present disclosure are not limited thereto. The control signal may be received through the pad part PAD. For example, in the non-display area NA, there may be disposed link wirings LL for transmitting a signal. For example, driving components such as the flexible circuit board 157 and the printed circuit board 160 may be connected to the pad part PAD.

According to the present disclosure, the non-display area NA may include a first non-display area NA1, a bending area BA, and a second non-display area NA2. For example, the first non-display area NA1 may be an area surrounding at least a portion of the display area AA. The bending area BA may be an area which is bendable and extends from at least one of a plurality of sides of the first non-display area NA1. The second non-display area NA2 may be an area which extends from the bending area BA, and in which the pad part PAD may be disposed. For example, the bending area BA may be in a bent state, and the remaining area of the substrate 110 except the bending area BA may be in a flat state. In this case, as the bending area BA is bent, the second non-display area NA2 can be located on the rear surface of the display area AA. However, the embodiments of the present disclosure are not limited thereto.

The display area AA of the substrate 110 or the display device 1000 may be configured in various shapes depending on the designs of the display device 1000. For example, the display area AA may be configured in a rectangular shape with four rounded corners, but the embodiments of the present disclosure are not limited thereto. For another example, the display area AA may be configured in a rectangular shape with four right angles, a circular shape, or the like, but the embodiments of the present disclosure are not limited thereto.

According to the present disclosure, the width of the second non-display area NA2 in which a plurality of pad electrodes PE are disposed may be greater than the width of the bending area BA in which the plurality of link wirings LL are disposed. Additionally, the width of the display area AA in which the plurality of sub-pixels are disposed may be greater than the width of the bending area BA in which only the plurality of link wirings LL are disposed. Although the width of the bending area BA is depicted in the drawing as being smaller than the widths of other areas of the substrate 110, the shape of the substrate 110 including such bending area BA is given only as an example, and the embodiments of the present disclosure are not limited thereto.

Referring to FIG. 3, in the display area AA, there may be disposed a plurality of pixel driving circuits PD. The plurality of pixel driving circuits PD may be circuits for driving light-emitting elements of a plurality of sub-pixels. Each of the plurality of pixel driving circuits PD may include a plurality of transistors including a driving transistor, a storage capacitor and the like, and may control the light-emitting operation of the plurality of light-emitting elements by supplying a control signal, power, and a driving current to the light-emitting elements of the plurality of sub-pixels. For example, a pixel driving circuit PD may include a power wiring and a signal wiring for controlling the on/off and/or light-emitting time of a light-emitting element. For example, the plurality of pixel driving circuits PD may be driving chips manufactured on a semiconductor substrate using a MOSFET (Metal-oxide-silicon field effect transistor) manufacturing process, but the embodiments of the present disclosure are not limited thereto. The driving chip may include a plurality of pixel driving circuits PD and may drive a plurality of sub-pixels. For example, the plurality of pixel driving circuits PD may include a micro driver µDriver, but the embodiments of the present disclosure are not limited thereto. For example, the plurality of pixel driver circuits PD may include a driving chip, but the embodiments of the present disclosure are not limited thereto.

Referring to FIG. 1 together, the flexible circuit board 157 and the printed circuit board 160 may be disposed at the lower side of the display panel 100. The flexible circuit board 157 and the printed circuit board 160 may be disposed at least on one edge of the display panel 100, but the embodiments of the present disclosure are not limited thereto. The flexible circuit board 157 may be attached to the display panel 100 at its one side, and to the printed circuit board 160 at another side thereof, but the embodiments of the present disclosure are not limited thereto. The flexible circuit board 157 may be configured with a flexible film, but the embodiments of the present disclosure are not limited thereto.

In the second non-display area NA2, the pad part PAD may be disposed, which includes the plurality of pad electrodes PE. To the pad part PAD a driving component including one or more flexible circuit boards (or flexible films) 157 and the printed circuit boards 160 may be attached or bonded. The plurality of pad electrodes PE of the pad part PAD may be electrically connected to one or more flexible circuit boards (or flexible films) 157 to transmit various signals or power from the printed circuit board 160 and the flexible circuit board (or flexible film) 157 to the plurality of pixel driving circuits PD in the display area AA.

The flexible circuit board (or flexible film) 157 may be configured with a film whose base film has a flexibility and is provided with various components disposed thereon. For example, the flexible circuit board (or flexible film) 157 may be provided with a driving integrated circuit (IC) such as a gate driving IC or a data driving IC disposed thereon, but the embodiments of the present disclosure are not limited thereto. The driving IC may be a kind of a component that processes data and driving signals for displaying an image. The driving IC may be disposed in a manner such as a Chip On Glass (COG), a Chip On Film (COF), or a Tape Carrier Package (TCP) depending on the mounting method, but the embodiments of the present disclosure are not limited thereto. The flexible circuit board (or flexible film) 157 may be attached or bonded onto the plurality of pad electrodes PE via a conductive adhesive layer, but the embodiments of the present disclosure are not limited thereto.

The printed circuit board 160 may be a kind of a component electrically connected to one or more flexible circuit boards (or flexible films) 157 to supply signals to the driving IC. The printed circuit board 160 may be disposed at one side of the flexible circuit board (or flexible film) 157 to be electrically connected to the flexible circuit board (or flexible film) 157. On the printed circuit board 160, there may be disposed a range of components for supplying various signals to the driving IC. For example, on the printed circuit board 160 a variety of components, including a timing controller, a power supply, a memory, a processor, or the like, may be disposed. For example, the printed circuit board 160 may be provided with a power management integrated circuit (PMIC), but the embodiments of the present disclosure are not limited thereto.

The printed circuit board 160 may include at least one hole 180, but the embodiments of the present disclosure are not limited thereto. In an area corresponding to at least one hole 180, there may be disposed an internal component detecting ambient light, temperature or the like, which may be provided with a plurality of sensors. For example, the internal component may include an ambient light sensor (ALS) or a temperature sensor, but embodiments of the present disclosure are not limited thereto. For example, the hole 180 may be a kind of a permeable hole, but the embodiments of the present disclosure are not limited thereto.

Referring to FIG. 1, the polarizing layer 293 may be disposed on the display panel 100. The polarizing layer 293 can prevent or alleviate a phenomenon in which the light generated by an external light source enters the inside of the display panel 100 and affects the light-emitting element or the like.

The cover member 155 may be disposed on the polarizing layer 293. The cover member 155 may be a member for protecting the display panel 100. The adhesive layer 295 may be disposed between the polarizing layer 293 and the cover member 155. By the adhesive layer 295 the cover member 155 can be attached to the display panel 100. The adhesive layer 295 may include an optically clear adhesive (OCA), an optically clear resin (OCR), a pressure sensitive adhesive (PSA), or the like, but the embodiments of the present disclosure are not limited thereto.

The support substrate 145 may be disposed between the display panel 100 and the printed circuit board 160. The support substrate 145 can reinforce the rigidity of the display panel 100. The support substrate 145 may be a kind of a back plate, but the embodiments of the present disclosure are not limited thereto.

Referring to FIGS. 1 to 3, the plurality of link wirings LL may be disposed in the non-display area NA. The plurality of link wirings LL may be wirings that transmit various signals from one or more flexible circuit boards (or flexible films) 157 and the printed circuit boards 160 to the display area AA. The plurality of link wirings LL may extend from the plurality of pad electrodes PE in the second non-display area NA2 toward the bending area BA and the first non-display area NA1 to be electrically connected to a plurality of driving wirings VL in the display area AA. The plurality of pixel driving circuits PD can be driven by receiving signals from one or more flexible circuit boards (or flexible films) 157 and printed circuit boards 160 through the driving wirings VL in the display area AA and the link wirings LL in the non-display area NA.

For example, the plurality of driving wirings VL may be wirings for transmitting signals output from the flexible circuit board (or flexible film) 157 and the printed circuit board 160 to the plurality of pixel driving circuits PD together with the plurality of link wirings LL. The plurality of driving wirings VL may be disposed in the display area AA to be electrically connected to each of the plurality of pixel driving circuits PD. The plurality of driving wirings VL may extend from the display area AA toward the non-display area NA to be electrically connected to the plurality of link wirings LL. Therefore, the signals output from the flexible circuit board (or flexible film) 157 and the printed circuit board 160 can be transmitted to each of the plurality of pixel driving circuits PD through the plurality of link wirings LL and the plurality of driving wirings VL.

When the bending area BA is bent, portions of the plurality of link wirings LL may be also bent together. Stress may be concentrated on a portion of the bent link wiring LL, which may cause cracks to occur in the link wiring LL. So, the plurality of link wirings LL may be configured with a conductive material having excellent ductility to reduce the cracks when the bending area BA is bent. For example, the plurality of link wirings LL may be configured with a conductive material having excellent ductility, such as gold (Au), silver (Ag), aluminum (Al) or the like, but the embodiments of the present disclosure are not limited thereto. Alternatively, the plurality of link wirings LL may be configured with one of various conductive materials used in the display area AA. For example, the plurality of link wirings LL may be configured with molybdenum (Mo), chromium (Cr), titanium (Ti), nickel (Ni), neodymium (Nd), copper (Cu), and an alloy of silver (Ag) and magnesium (Mg), or any alloy thereof, but the embodiments of the present disclosure are not limited thereto. The plurality of link wirings LL may be configured in a multilayer structure including various conductive materials. For example, the plurality of link wirings LL may be configured in a triple layer structure of titanium (Ti)/aluminum (Al)/titanium (Ti), but the embodiments of the present disclosure are not limited thereto.

The plurality of link wirings LL may be configured in various shapes to reduce stress. At least a portion of the plurality of link wirings LL disposed on the bending area BA may extend in the same direction as the extension direction of the bending area BA, or in a direction different from the extension direction of the bending area BA, to reduce stress. For example, in a case where the bending area BA extends in one direction from the first non-display area NA1 toward the second non-display area NA2, at least a portion of the link wiring LL disposed on the bending area BA may extend in a direction transverse to the one direction. As another example, at least a portion of the plurality of link wirings LL may be configured in patterns of various shapes. For example, at least a portion of the plurality of link wirings LL disposed on a bending area BA may have a shape in which a conductive pattern having at least one shape of a diamond shape, a rhombus shape, a trapezoidal wave shape, a triangular wave shape, a sawtooth wave shape, a sine wave shape, a circular shape, and an omega (Ω) shape may be repeatedly disposed, but the embodiments of the present disclosure are not limited thereto. Therefore, in order to minimize the stress concentrated on the plurality of link wirings LL and the resulting cracks, the shape of the plurality of link wirings LL may be formed in various shapes including the shapes described above, but the embodiments of the present disclosure are not limited thereto.

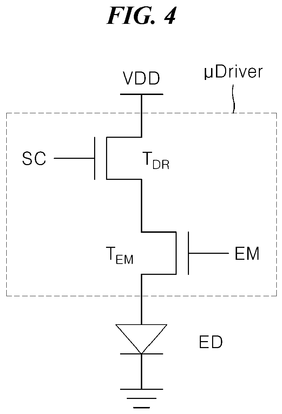

FIG. 4 is a diagram showing a circuit structure according to an embodiment of the present disclosure.

In FIG. 4, one light-emitting element ED is, by way of example, connected to a micro driver µDriver, but the embodiments of the present invention are not limited thereto. For example, eight light-emitting elements (LEDs) may be connected to one micro driver µDriver. As another example, sixteen light-emitting elements ED may be connected to one micro driver µDriver, or thirty two light-emitting elements ED or sixty four light-emitting elements ED may be connected to one micro driver µDriver simultaneously. The light-emitting element ED may be a micro light-emitting element (µLED).

One micro driver µDriver may include a driving transistor T_{DR} and a light-emitting transistor T_{EM}, but embodiments of the present disclosure are not limited thereto.

For example, the driving transistor T_{DR} may have a first electrode to which a high-potential power supply voltage VDD is applied, a second electrode to which a first electrode of the light-emitting transistor T_{EM} is connected, and a gate electrode to which a scan signal SC is applied. The scan signal SC applied to the gate electrode of the driving transistor T_{DR} may be a direct current (DC) power source, and a fixed reference voltage (Vref) may be applied every frame, but the embodiments of the present disclosure are not limited thereto.

The light-emitting transistor T_{EM} may have the first electrode to which the second electrode of the driving transistor T_{DR} is connected, a second electrode to which the light-emitting element ED is connected, and a gate electrode to which a light-emitting signal EM is applied. The light-emitting signal EM applied to the gate electrode of the light-emitting transistor T_{EM} may be a pulse width modulation (PWM) signal that varies every frame, but the embodiments of the present disclosure are not limited thereto.

The light-emitting element ED may have the first electrode connected to the second electrode of the light-emitting transistor T_{EM}, and a second electrode connected to ground. For example, the first electrode may be an anode electrode, and the second electrode may be a cathode electrode, but the embodiments of the present disclosure are not limited thereto.

The driving transistor T_{DR} and the light-emitting transistor T_{EM} may each be an n-type or a p-type transistor.

In the micro driver µDriver, the driving transistor T_{DR} may be turned on by the scan signal SC applied from the timing controller (T-CON), and the light-emitting transistor T_{EM} may be turned on by the light-emitting signal EM. By this, a driving current can be applied to the light-emitting element ED via the driving transistor T_{DR} and the light-emitting transistor T_{EM} by the high-potential power supply voltage VDD applied to the first electrode of the driving transistor T_{DR}, thereby causing the light-emitting element ED to emit light.

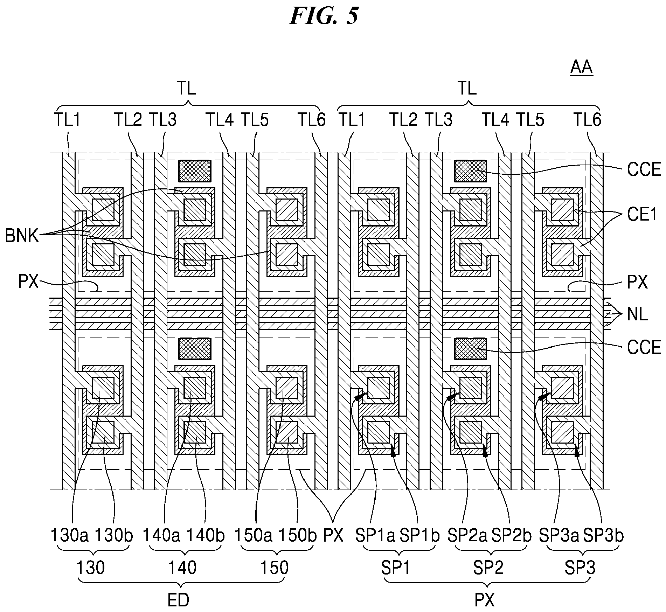

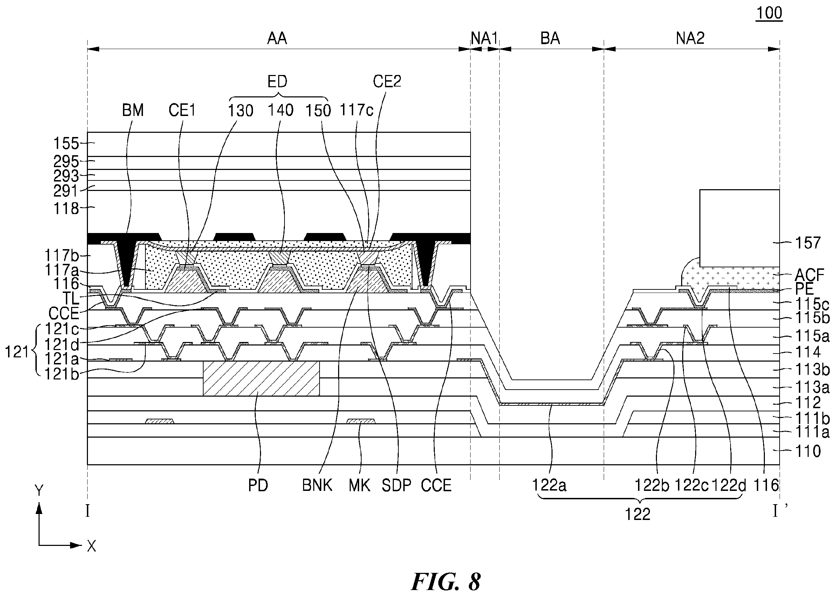

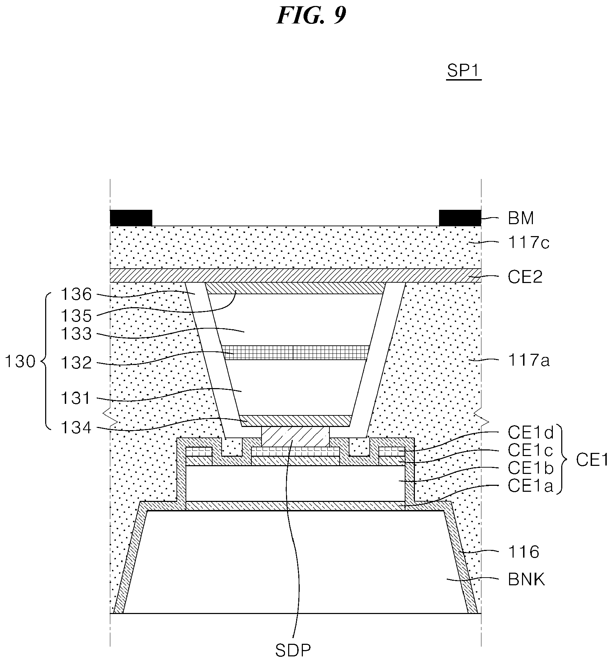

FIGS. 5 to 7 are plan views of a display device according to an embodiment of the present disclosure. FIGS. 8 and 9 are cross-sectional views of a display device according to an embodiment of the present disclosure.

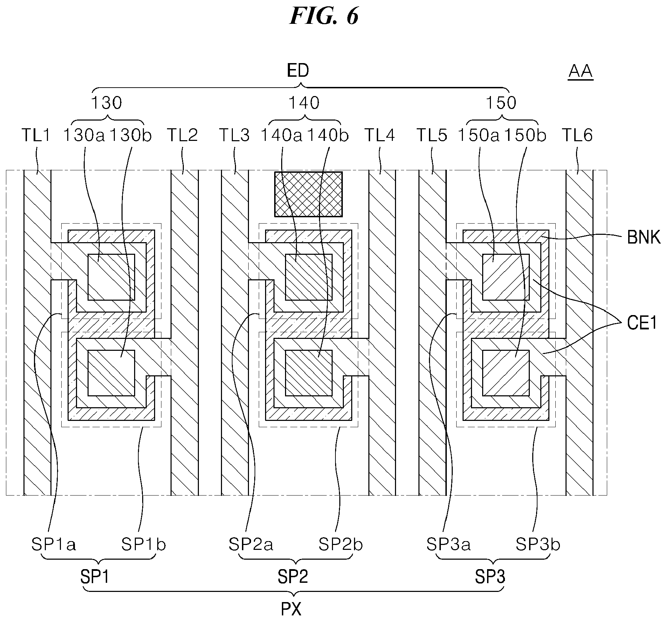

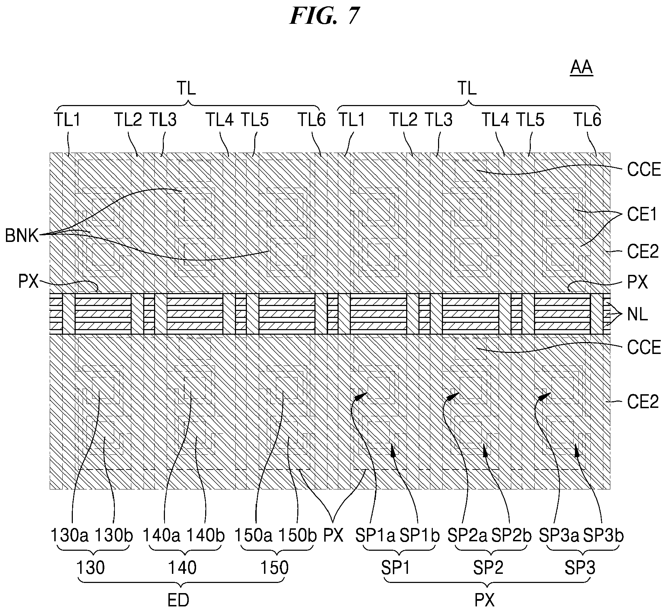

For example, FIG. 5 is an enlarged plan view of a display area including a plurality of pixels. For example, FIG. 6 is an enlarged plan view of a display area including one pixel. For example, FIG. 7 is an enlarged plan view of a display area including a plurality of pixels. For example, FIG. 8 is a cross-sectional view of the display area AA, the first non-display area NA, the bending area BA, and the second non-display area NA2. For example, FIG. 8 is a cross-sectional view taken along line I-I' of FIG. 2. For example, FIG. 9 is a cross-sectional view of a display area including one sub-pixel SP1. In FIGS. 5 and 6, only a plurality of signal wirings TL, a plurality of communication wirings NLs, a plurality of first electrodes CE1, a plurality of banks BNK, and a plurality of light-emitting elements ED are illustrated, but the embodiments of the present disclosure are not limited thereto. FIG. 7 is an enlarged plan view in which a plurality of second electrodes CE2 are additionally disposed to FIG. 5.

Referring to FIGS. 5, 6, and 9, a plurality of pixels PX configured with a plurality of sub-pixels may be disposed in the display area AA. Each of the plurality of sub-pixels may include a light-emitting element ED and can independently emit light. The plurality of sub-pixels may be disposed in a matrix form, forming a plurality of rows and a plurality of columns, but the embodiments of the present disclosure are not limited thereto.

The plurality of sub-pixels may include a first sub-pixel SP1, a second sub-pixel SP2, and a third sub-pixel SP3. For example, one of the first sub-pixel SP1, the second sub-pixel SP2 and the third sub-pixel SP3 may be a red sub-pixel, another thereof may be a green sub-pixel, and the remaining one thereof may be a blue sub-pixel. The types of the plurality of sub-pixels are given only as an example, and the embodiments of the present disclosure are not limited thereto.

Each of the plurality of pixels PX may include one or more first sub-pixels SP1, one or more second sub-pixels SP2, and one or more third sub-pixels SP3. For example, one pixel PX may include a pair of first sub-pixels SP1, a pair of second sub-pixels SP2, and a pair of third sub-pixels SP3. The pair of first sub-pixels SP1 may be configured with a (1-1)-th sub-pixel SP1a and a (1-2)-th sub-pixel SP1b. The pair of second sub-pixels SP2 may be configured with a (2-1)-th sub-pixel SP2a and a (2-2)-th sub-pixel SP2b. The pair of third sub-pixels SP3 may be configured with a (3-1)-th sub-pixel SP3a and a (3-2)-th sub-pixel SP3b. For example, one pixel PX may include the (1-1)-th sub-pixel SP1a and the (1-2)-th sub-pixel SP1b, the (2-1)-th sub-pixel SP2a and the (2-2)-th sub-pixel SP2b, and the (3-1)-th sub-pixel SP3a and the (3-2)-th sub-pixel SP3b, but the embodiments of the present disclosure are not limited thereto.

The plurality of sub-pixels constituting one pixel PX may be arranged in various ways. For example, in one pixel PX, the pair of first sub-pixels SP1 may be disposed in the same column, the pair of second sub-pixels SP2 may be disposed in the same column, and the pair of third sub-pixels SP3 may be disposed in the same column. The first sub-pixel SP1, the second sub-pixel SP2, and the third sub-pixel SP3 may be disposed in the same row. The number and arrangement of the plurality of sub-pixels constituting one pixel PX are given only as an example, and the embodiments of the present disclosure are not limited thereto.

The plurality of signal wirings TL may be disposed in the area between a plurality of sub-pixels. The plurality of signal wirings TL may extend in the column direction between the plurality of sub-pixels. The plurality of signal wirings TL may be wirings that transmit the anode voltage from the pixel driving circuit PD to the plurality of sub-pixels. For example, the plurality of signal wirings TL may be electrically connected to the plurality of pixel driving circuits PD and first electrodes CE1s of the plurality of sub-pixels. The anode voltage output from the pixel driving circuit PD may be transmitted to the first electrodes CE1s of the plurality of sub-pixels through the plurality of signal wirings TL. For example, the first electrode CE1 may be an electrode electrically connected to an anode electrode 134 of the light-emitting element ED. By this, the anode voltage from the signal wiring TL can be transmitted to the anode electrode 134 of the light-emitting element ED through the first electrode CE1.

Therefore, instead of forming a plurality of transistors and storage capacitors in each of the plurality of sub-pixels, by using the pixel driving circuit PD in which a plurality of pixel circuits are integrated, the structure of the display device 1000 can be simplified. In addition, since the circuits disposed in each of the plurality of sub-pixels are integrated into one pixel driving circuit PD, high-efficiency and low-power driving can be realized.

The plurality of signal wirings TL may include a first signal wiring TL1, a second signal wiring TL2, a third signal wiring TL3, a fourth signal wiring TL4, a fifth signal wiring TL5, and a sixth signal wiring TL6. Each of the first signal wiring TL1 and the second signal wiring TL2 may be electrically connected to the pair of first sub-pixels SP1. Each of the third signal wiring TL3 and the fourth signal wiring TL4 may be electrically connected to the pair of second sub-pixels SP2. Each of the fifth signal wiring TL5 and the sixth signal wiring TL6 may be electrically connected to the pair of third sub-pixels SP3.

The first signal wiring TL1 may be disposed at one side of the pair of first sub-pixels SP1, and the second signal wiring TL2 may be disposed at another side of the pair of first sub-pixels SP1. The first signal wiring TL1 may be electrically connected to the first electrode CE1 of one of the first sub-pixels SP1 of the pair of first sub-pixels SP1, for example, the (1-1)-th sub-pixel SP1a. The second signal wiring TL2 may be electrically connected to the first electrode CE1 of the remaining first sub-pixel SP1 of the pair of first sub-pixels SP1, for example, the (1-2)-th sub-pixel SP1b.

The third signal wiring TL3 may be disposed at one side of the pair of second sub-pixels SP2, and the fourth signal wiring TL4 may be disposed at another side of the pair of second sub-pixels SP2. For example, the third signal wiring TL3 may be disposed neighboring the second signal wiring TL2. The third signal wiring TL3 may be electrically connected to the first electrode CE1 of one of the second sub-pixels SP2 of the pair of second sub-pixels SP2, for example, the (2-1)-th sub-pixel SP2a. The fourth signal wiring TL4 may be electrically connected to the first electrode CE1 of the remaining second sub-pixel SP2 of the pair of second sub-pixels SP2, for example, the (2-2)-th sub-pixel SP2b.

The fifth signal wiring TL5 may be disposed at one side of the pair of third sub-pixels SP3, and the sixth signal wiring TL6 may be disposed at another side of the pair of third sub-pixels SP3. For example, the fifth signal wiring TL5 may be disposed neighboring the fourth signal wiring TL4. The sixth signal wiring TL6 may be disposed neighboring the first signal wiring TL1 connected to the neighboring pixel PX. The fifth signal wiring TL5 may be electrically connected to the first electrode CE1 of one of the third sub-pixels SP3 of the pair of third sub-pixels SP3, for example, the (3-1)-th sub-pixel SP3a. The sixth signal wiring TL6 may be electrically connected to the first electrode CE1 of the remaining third sub-pixel SP3 of the pair of third sub-pixels SP3, for example, the (3-2)-th sub-pixel SP3b.

The plurality of signal wirings TL may be configured with a conductive material. For example, the plurality of signal wirings TL may be configured with a conductive material such as titanium (Ti), aluminum (Al), copper (Cu), molybdenum (Mo), nickel (Ni), chromium (Cr), indium tin oxide (ITO), indium zinc oxide (IZO), indium gallium zinc oxide (IGZO), or the like, but the embodiments of the present disclosure are not limited thereto. As another example, the plurality of signal wirings TL may be formed of a multilayer structure of conductive material. For example, the plurality of signal wirings TL may be configured in a multilayer structure of titanium (Ti)/aluminum (AI)/titanium (Ti)/indium tin oxide (ITO), but the embodiments of the present disclosure are not limited thereto.

The plurality of communication wirings NLs may be disposed in an area between the plurality of pixels PX. The plurality of communication lines NLs may be disposed to extend in the row direction in the area between the plurality of pixels PX. The plurality of communication wirings NLs may be disposed in an area between the plurality of second electrodes CE2s and may not overlap with the plurality of second electrodes CE2s. For example, the plurality of communication wirings NL may be wirings used for short-range communication such as Near Field Communication (NFC). The plurality of communication wirings NL may function as antennas. For example, the plurality of communication wirings NL may be a plurality of connection wirings or the like, but the embodiments of the present disclosure are not limited thereto.

According to the present disclosure, the bank BNK may be disposed in each of the plurality of sub-pixels. A plurality of banks BNK may be structures on which a plurality of light-emitting elements ED are mounted. The plurality of banks BNK can guide the positions of the plurality of light-emitting elements ED in a transfer process during which the plurality of light-emitting elements ED are transferred to the display device 1000. In a transfer process of a plurality of light-emitting elements ED, a plurality of light-emitting elements ED may be transferred onto a plurality of banks BNK. The plurality of banks BNK may be bank patterns or structures, but the embodiments of the present disclosure are not limited thereto.

The bank BNK of the first sub-pixel SP1, the bank BNK of the second sub-pixel SP2, and the bank BNK of the third sub-pixel SP3 may be disposed spaced apart from each other. The bank BNK of the first sub-pixel SP1, the bank BNK of the second sub-pixel SP2, and the bank BNK of the third sub-pixel SP3 may be configured to be separated from each other. Accordingly, the banks BNK of the first sub-pixel SP1, the second sub-pixel SP2, and the third sub-pixel SP3 to which different types of light-emitting elements ED are transferred can be easily identified.

The bank BNK of the (1-1)-th sub-pixel SP1a and the bank BNK of the (1-2)-th sub-pixel SP1b may be connected to each other or may be formed to be spaced apart or separated from each other. For example, depending on the consideration of design requirements and the like of the transfer process, the bank BNK of the (1-1)-th sub-pixel SP1a and the bank BNK of the (1-2)-th sub-pixel SP1b in which the light-emitting elements ED of the same type are disposed may be connected to each other, or may be spaced apart or separated from each other. Furthermore, the bank BNK of the (2-1)-th sub-pixel SP2a and the bank BNK of the (2-2)-th sub-pixel SP2b may be connected to each other or may be formed to be spaced apart or separated from each other. The bank BNK of the (3-1)-th sub-pixel SP3a and the bank BNK of the (3-2)-th sub-pixel SP3b may be connected to each other or may be formed to be spaced apart or separated from each other. Accordingly, the banks BNK of the pair of first sub-pixels SP1, the banks BNK of the pair of second sub-pixels SP2, and the banks BNK of the pair of third sub-pixels SP3 can be formed in various ways, and so the embodiments of the present disclosure are not limited thereto.

For example, the plurality of banks BNK may be configured with an organic insulating material. The plurality of banks BNK may be configured in a single-layer or multi-layer structure of organic insulating material. For example, the plurality of banks BNK may be configured with a photo resist, polyimide (PI), or acrylic-based material, or the like, but the embodiments of the present disclosure are not limited thereto.

The first electrode CE1 may be disposed on each of the plurality of sub-pixels. The first electrode CE1 may be disposed on the bank BNK. The first electrode CE1 may be electrically connected to one of the plurality of signal wirings TL. At least a portion of the first electrode CE1 may extend outside of the bank BNK to be electrically connected to a signal wiring TL closest to the first electrode CE1. For example, a portion of the first electrode CE1 of the (1-1)-th sub-pixel SP1a may extend to one side area of the (1-1)-th sub-pixel SP1a to be electrically connected to the first signal wiring TL1, and a portion of the first electrode CE1 of the (1-2)-th sub-pixel SP1b may extend to another side area of the (1-2)-th sub-pixel SP1b to be electrically connected to the second signal wiring TL2. A portion of the first electrode CE1 of the (2-1)-th sub-pixel SP2a may extend to one side area of the (2-1)-th sub-pixel SP2a to be electrically connected to the third signal wiring TL3, and a portion of the first electrode CE1 of the (2-2)-th sub-pixel SP2b may extend to another side area of the (2-2)-th sub-pixel SP2b to be electrically connected to the fourth signal wiring TL4. A portion of the first electrode CE1 of the (3-1)-th sub-pixel SP3a may extend to one side area of the (3-1)-th sub-pixel SP3a to be electrically connected to the fifth signal wiring TL5, and a portion of the first electrode CE1 of the (3-2)-th sub-pixel SP3b may extend to another side area of the (3-2)-th sub-pixel SP3b to be electrically connected to the sixth signal wiring TL6.

The first electrode CE1 may be electrically connected to the anode electrode 134 of the light-emitting element ED to transmit the anode voltage from the pixel driving circuit PD to the light-emitting element ED through the signal wiring TL. To the first electrode CE1 of each of the plurality of sub-pixels, a different voltage may be applied depending on the image to be displayed. For example, a different voltage may be applied to the first electrode CE1 of each of the plurality of sub-pixels. By this, the first electrode CE1 may be a pixel electrode, and the embodiments of the present disclosure are not limited thereto.

The first electrode CE1 may be configured with a conductive material. For example, the first electrode CE1 may be configured as one body with a plurality of signal wirings TL. For example, the first electrode CE1 may be configured with the same conductive material as the plurality of signal wirings TL, but the embodiments of the present disclosure are not limited thereto. For example, the first electrode CE1 may be configured with a conductive material such as titanium (Ti), aluminum (Al), copper (Cu), molybdenum (Mo), nickel (Ni), chromium (Cr), indium tin oxide (ITO), indium zinc oxide (IZO), indium gallium zinc oxide (IGZO), or the like, but the embodiments of the present disclosure are not limited thereto. As another example, the first electrode CE1 may be configured in a multilayer structure of conductive material. For example, the plurality of first electrode CE1 may be configured in a multilayer structure of titanium (Ti)/aluminum (Al)/titanium (Ti)/indium tin oxide (ITO), but the embodiments of the present disclosure are not limited thereto.

The light-emitting element ED may be disposed in each of the plurality of sub-pixels. The plurality of light-emitting elements ED may be any one of a light-emitting diode (LED) and a micro light-emitting diode (micro LED), but the embodiments of the present disclosure are not limited thereto. The plurality of light-emitting elements ED may be disposed on the bank BNK and the first electrode CE1. The plurality of light-emitting elements ED may be disposed on the first electrode CE1 to be electrically connected to the first electrode CE1. Therefore, the light-emitting element ED can emit light by receiving an anode voltage from the pixel driving circuit PD through the signal wiring TL and the first electrode CE1.

The plurality of light-emitting elements ED may include a first light-emitting element 130, a second light-emitting element 140, and a third light-emitting element 150. The first light-emitting element 130 may be disposed in the first sub-pixel SP1. The second light-emitting element 140 may be disposed in the second sub-pixel SP2. The third light-emitting element 150 may be disposed in the third sub-pixel SP3. For example, one of the first light-emitting element 130, the second light-emitting element 140, and the third light-emitting element 150 may be a red light-emitting element, another thereof may be a green light-emitting element, and the remaining one thereof may be blue light-emitting elements, but the embodiments of the present disclosure are not limited thereto. Accordingly, by combining red light, green light, and blue light emitted from the plurality of light-emitting elements ED, light of various colors, including white, can be implemented. The types of the plurality of light-emitting elements ED are given only as an example, and the embodiments of the present disclosure are not limited thereto.

The first light-emitting element 130 may include a (1-1)-th light-emitting element 130a disposed in the (1-1)-th sub-pixel SP1a and a (1-2)-th light-emitting element 130b disposed in the (1-2)-th sub-pixel SP1b. The second light-emitting element 140 may include a (2-1)-th light-emitting element 140a disposed in the (2-1)-th sub-pixel SP2a and a (2-2)-th light-emitting element 140b disposed in the (2-2)-th sub-pixel SP2b. The third light-emitting element 150 may include a (3-1)-th light-emitting element 150a disposed in the (3-1)-th sub-pixel SP3a and a (3-2)-th light-emitting element 150b disposed in the (3-2)-th sub-pixel SP3b.

Referring to FIGS. 5, 6, 7, and 9 together, the second electrode CE2 may be disposed on each of the plurality of sub-pixels. The second electrode CE2 may be disposed on the light-emitting element ED. The second electrode CE2 may be electrically connected to the pixel driving circuit PD through a plurality of contact electrodes CCE.

For example, the second electrode CE2 may be electrically connected to the cathode electrode 135 of the light-emitting element ED to transmit the cathode voltage from the pixel driving circuit PD to the light-emitting element ED. The same cathode voltage may be applied to the second electrode CE2 of each of the plurality of sub-pixels. For example, the same voltage may be applied to the second electrode CE2 of each of the plurality of sub-pixels and the cathode electrode 135 of the light-emitting element ED. By this, the second electrode CE2 may be a common electrode, but the embodiments of the present disclosure are not limited thereto.

At least some of the plurality of sub-pixels may share the second electrode CE2 with each other. At least some of the second electrodes CE2 of the plurality of respective sub-pixels may be electrically connected to each other. As the same voltage is applied to the second electrodes CE2, the second electrode CE2 can be shared to be used for at least some sub-pixels. For example, the second electrodes CE2 of at least some of the pixels PX among the plurality of pixels PX disposed in the same row may be connected to each other. For example, one second electrode CE2 may be disposed on a plurality of pixels PX. One second electrode CE2 may be disposed for every n sub-pixels.

For example, some of the second electrodes CE2 of the plurality of respective sub-pixels may be disposed to be spaced apart from or separated from each other. For example, the second electrode CE2 connected to the pixels PX of the nth row and the second electrode CE2 connected to the pixels PX of the n+1th row may be disposed to be spaced apart from each other or separated from each other. For example, the plurality of second electrodes CE2 may be disposed to be spaced apart from each other with a plurality of communication wirings NL interposed and extending therebetween in the row direction. Thus, the number of the plurality of sub-pixels can be greater than the number of the plurality of second electrodes CE2. As another example, all of the second electrodes CE2 of a plurality of sub-pixels may be connected to each other so that only one second electrode CE2 is placed on the substrate 110, but the embodiments of the present disclosure are not limited thereto.

The plurality of second electrodes CE2 may be configured with a transparent conductive material, but the embodiments of the present disclosure are not limited thereto. The plurality of second electrodes CE2 may be configured with a transparent conductive material, so that light emitted from the light-emitting element ED can be directed toward the upper side of the second electrodes CE2. For example, the second electrode CE2 may be configured with a transparent conductive material such as indium tin oxide (ITO), indium zinc oxide (IZO), indium gallium zinc oxide (IGZO), or the like, but the embodiments of the present disclosure are not limited thereto.

The plurality of contact electrodes CCE may be disposed on the substrate 110. For example, the plurality of contact electrodes CCE may be disposed to be spaced apart from the plurality of banks BNK and the plurality of signal wirings TL. Each of the plurality of second electrodes CE2 may overlap with at least one contact electrode CCE. For example, one second electrode CE2 may overlap with the plurality of contact electrodes CCE.

For example, a plurality of contact electrodes CCE may be electrically connected to a plurality of second electrodes CE2. The plurality of contact electrodes CCE may be disposed between the substrate 110 and the plurality of second electrodes CE2 to transmit the cathode voltage from the pixel driving circuit PD to the second electrodes CE2.

For example, in a case where a micro LED is used as the light-emitting element ED, a plurality of micro LEDs may be formed on a wafer, and the micro LEDs may be transferred to the substrate 110 of the display device 1000to manufacture the display device 1000. In the process of transferring a plurality of light-emitting elements ED having a microscopic size from the wafer to the substrate 110, various defects may be formed. For example, in some sub-pixels, a non-transfer defect may occur in which the light-emitting element ED is not transferred, and in other some sub-pixels, a defect may occur in which the light-emitting element ED is transferred outside the predetermined position due to an alignment error. Additionally, although the transfer process has been performed normally, the transferred light-emitting element ED itself may be defective. Therefore, taking into account the defects produced during the transfer process of the plurality of light-emitting elements ED, a plurality of light-emitting elements ED of the same type may be transferred to one sub-pixel. Lighting tests may be performed on the plurality of light-emitting elements ED, and only one light-emitting element ED that is ultimately determined to be normal may be used.

For example, the (1-1)-th light-emitting element 130a and the (1-2)-th light-emitting element 130b may be transferred together to one pixel PX and may be tested to find whether they are defective or not. If both the (1-1)-th light-emitting element 130a and the (1-2)-th light-emitting element 130b are determined to be normal, only the (1-1)-th light-emitting element 130a may be used, and the (1-2)-th light-emitting element 130b may not be used. As another example, if the (1-2)-th light-emitting element 130b among the (1-1)-th light-emitting element 130a and the (1-2)-th light-emitting element 130b is determined to be normal, the (1-1)-th light-emitting element 130a may not be used and the (1-2)-th light-emitting element 130b may be used. Therefore, even if a plurality of light-emitting elements ED of the same type are transferred to one pixel PX, only one light-emitting element ED can be used ultimately.

Accordingly, one of the pair of light-emitting elements ED may be a main or primary light-emitting element ED, and the other light-emitting element ED thereof may be a redundant light-emitting element ED. The redundant light-emitting element ED may be a spare light-emitting element ED that has been transferred to prepare for failure of the main light-emitting element ED. In case of the failure of the main light-emitting element ED, the redundant light-emitting element ED can be used as a replacement for it. Therefore, by transferring the main light-emitting element ED and the redundant light-emitting element ED together to one pixel PX, the deterioration of display quality due to defects in the main light-emitting element ED and the redundant light-emitting element ED can be minimized.

For example, the (1-1)-th light-emitting element 130a, the (2-1)-th light-emitting element 140a, and the (3-1)-th light-emitting element 150a transferred to one pixel PX may be used as main light-emitting elements ED, while the (1-2)-th light-emitting element 130b, the (2-2)-th light-emitting element 140b, and the (3-2)-th light-emitting element 150b may be used as redundant light-emitting elements ED.

FIG. 8 is a cross-sectional view of a display device according to an embodiment of the present disclosure. FIG. 9 is a cross-sectional view of a display device according to an embodiment of the present disclosure. For example, FIG. 8 is a cross-sectional view of the display area AA, the first non-display area NA, the bending area BA, and the second non-display area NA2. FIG. 8 is a cross-sectional view taken along line I-I' of FIG. 2. For example, FIG. 9 is a cross-sectional view of a display area including one sub-pixel SP1.

Referring to FIG. 8, in the remaining area of the substrate 110 except the bending area BA a first buffer layer 111a and a second buffer layer 111b may be disposed.

The first buffer layer 111a and the second buffer layer 111b may be disposed in the display area AA, the first non-display area NA1, and the second non-display area NA2. The first buffer layer 111a and the second buffer layer 111b may reduce the penetration of moisture or impurities through the substrate 110. The first buffer layer 111a and the second buffer layer 111b may be configured with an inorganic insulating material. For example, the first buffer layer 111a and the second buffer layer 111b may be configured in a single-layer or multi-layer structure of silicon oxide (SiOx) or silicon nitride (SiNx), but the embodiments of the present disclosure are not limited thereto.

For example, a portion of the first buffer layer 111a and the second buffer layer 111b in the bending area BA may be removed. The upper surface of the substrate 110 located in the bending area BA may be exposed from the first buffer layer 111a and the second buffer layer 111b. By removing the first buffer layer 111a and the second buffer layer 111b configured with an inorganic insulating material from the bending area BA, it is possible to minimize the cracks that may be produced in the first buffer layer 111a and the second buffer layer 111b when being bent.

Between the first buffer layer 111a and the second buffer layer 111b a plurality of alignment keys MK may be disposed. The plurality of alignment keys MK may be configured to identify the position of the pixel driving circuit PD during the manufacturing process of the display device 1000. For example, the plurality of alignment keys MK may be configured to align the position of the pixel driving circuit PD transferred on the adhesive layer 112. As another example, the plurality of alignment keys MK may be omitted.

On the second buffer layer 111b the adhesive layer 112 may be disposed. The adhesive layer 112 may be disposed in the display area AA, the first non-display area NA1, the bending area BA, and the second non-display area NA2. As another example, at least a portion of the adhesive layer 112 may be removed from the non-display area NA including the bending area BA. For example, the adhesive layer 112 may be configured with any one of an adhesive polymer, an epoxy resin, a UV-curable resin, a polyimide series, an acrylate series, a urethane series, and polydimethylsiloxane (PDMS), but the embodiments of the present disclosure are not limited thereto.

On the adhesive layer 112 in the display area AA the pixel driving circuit PD may be disposed. In a case where the pixel driving circuit PD is implemented with a driving chip, the driving chip may be mounted on the adhesive layer 112 by a transfer process, but the embodiments of the present disclosure are not limited thereto.

On the adhesive layer 112 a first protective layer 113a and a second protective layer 113b may be disposed. The first protective layer 113a and the second protective layer 113b may be disposed to surround the side surface of the pixel driving circuit PD, but the embodiments of the present disclosure are not limited thereto. For example, the second protective layer 113b may be disposed to cover at least a portion of the upper surface of the pixel driving circuit PD. For example, at least one of the first protective layer 113a and the second protective layer 113b disposed on the bending area BA may be omitted. For example, the first protective layer 113a may be disposed entirely in the display area AA and the non-display area NA, and the second protective layer 113b may be disposed in part in the display area AA, the first non-display area NA1, and the second non-display area NA2. For example, a portion of the second protective layer 113b in the bending area BA may be removed. However, the embodiments of the present disclosure are not limited thereto.

The first protective layer 113a and the second protective layer 113b may be configured with an organic insulating material, but the embodiments of the present disclosure are not limited thereto. For example, the first protective layer 113a and the second protective layer 113b may be configured with a photo resist, polyimide (PI), or photo acryl-based material, or the like, but the embodiments of the present disclosure are not limited thereto. For example, the first protective layer 113a and the second protective layer 113b may be an overcoating layer or an insulating layer, but the embodiments of the present disclosure are not limited thereto.

According to the present disclosure, on the second protective layer 113b in the display area AA a plurality of first connection wirings 121 may be disposed. The plurality of first connection wirings 121 may be wirings for electrically connecting the pixel driving circuit PD with another component. For example, a pixel driving circuit PD may be electrically connected to the plurality of signal wirings TL, the plurality of contact electrodes CCE and the like through the plurality of first connection wirings 121. For example, the plurality of first connection wirings 121 may include a (1-1)-th connection wiring 121a, a (1-2)-th connection wiring 121b, a (1-3)-th connection wiring 121c, and a (1-4)-th connection wiring 121d, but the embodiments of the present disclosure are not limited thereto.

For example, a plurality of (1-1)-th connection wirings 121a may be disposed on the second protective layer 113b. The plurality of (1-1)-th connection wirings 121a may be electrically connected to the pixel driving circuit PD. The plurality of (1-1)-th connection wirings 121a can transmit a voltage output from the pixel driving circuit PD to the first electrode CE1 or the second electrode CE2.

For example, on the second protective layer 113b a third protective layer 114 may be disposed. The third protective layer 114 may be disposed entirely in the display area AA and the non-display area NA. In the bending area BA, the third protective layer 114 may cover or surround the side surface of the second protective layer 113b and the upper surface of the first protective layer 113a. The third protective layer 114 may be configured with an organic insulating material. For example, the third protective layer 114 may be configured with a photo resist, polyimide (PI), or photo acryl-based material, or the like, but the embodiments of the present disclosure are not limited thereto. For example, the first protective layer 113a, the second protective layer 113b, and the third protective layer 114 may be configured with the same material, but the embodiments of the present disclosure are not limited thereto.

On the third protective layer 114 a plurality of (1-2)-th connection wirings 121b may be disposed. The plurality of (1-2)-th connection wirings 121b may be connected to or directly connected to the pixel driving circuit PD. For example, a portion of the (1-2)-th connection wiring 121b may be directly connected to the pixel driving circuit PD through the contact hole in the third protective layer 114. Another portion of the (1-2)-th connection wiring 121b may be electrically connected to the (1-1)-th connection wiring 121a through the contact hole in the third protective layer 114. However, the embodiments of the present disclosure are not limited thereto. The voltage output from the pixel driving circuit PD may be transmitted to the first electrode CE1 or the second electrode CE2 through the plurality of (1-2)-th connection wirings 121b and another connection wiring.

On the plurality of (1-2)-th connection wirings 121b a first insulating layer 115a may be disposed. The first insulating layer 115a may be disposed entirely in the display area AA and the non-display area NA, but the embodiments of the present disclosure are not limited thereto. The first insulating layer 115a may be configured with an organic insulating material, but the embodiments of the present disclosure are not limited thereto. For example, the first insulating layer 115a may be configured with a photo resist, polyimide (PI), or photo acryl-based material, or the like, but the embodiments of the present disclosure are not limited thereto.

On the first insulating layer 115a a plurality of (1-3)-th connection wirings 121c may be disposed. The plurality of (1-3)-th connection wirings 121c may be electrically connected to the plurality of (1-2)-th connection wirings 121b. For example, the (1-3)-th connection wiring 121c may be electrically connected to the (1-2)-th connection wiring 121b through the contact hole in the first insulating layer 115a.

On the plurality of (1-3)-th connection wirings 121c a second insulating layer 115b may be disposed. The second insulating layer 115b may be disposed in the remaining area except the bending area BA, but the embodiments of the present disclosure are not limited thereto. The second insulating layer 115b may be disposed in the display area AA, the first non-display area NA1, and the second non-display area NA2, but the embodiments of the present disclosure are not limited thereto. For example, a portion of the second insulating layer 115b disposed in the bending area BA may be removed. The second insulating layer 115b may be configured with an organic insulating material, but the embodiments of the present disclosure are not limited thereto. For example, the second insulating layer 115b may be configured with a photo resist, polyimide (PI), or photo acryl-based material, or the like, but the embodiments of the present disclosure are not limited thereto.

On the second insulating layer 115b a plurality of (1-4)-th connection wirings 121d may be disposed. The plurality of (1-4)-th connection wirings 121d may be electrically connected to the plurality of (1-3)-th connection wirings 121c. For example, the (1-4)-th connection wiring 121d may be electrically connected to the (1-3)-th connection wiring 121c through the contact hole in the second insulating layer 115b.

According to the present disclosure, on the second protective layer 113b in the non-display area NA a plurality of second connection wirings 122 may be disposed. The plurality of second connection wirings 122 may be wirings for transmitting, to the pixel driving circuit PD in the display area AA, signals transmitted from the flexible circuit board (or flexible film) 157 and the printed circuit board 160 (see FIG. 1) to the pad part PAD. For example, the plurality of second connection wirings 122 may be electrically connected to the plurality of pad electrodes PE to receive signals from the flexible circuit board (or flexible film) 157 and the printed circuit board 160.

For example, the plurality of second connection wirings 122 may extend from the pad part PAD toward the display area AA to transmit signals to the wirings of the display area AA. In this case, the plurality of second connection wirings 122 may function as the link wirings LL. The plurality of second connection wirings 122 may include a (2-1)-th connection wiring 122a, a (2-2)-th connection wiring 122b, a (2-3)-th connection wiring 122c, and a (2-4)-th connection wiring 122d.

On the second protective layer 113b a plurality of (2-1)-th connection wirings 122a may be disposed. The plurality of (2-1)-th connection wirings 122a may extend from the second non-display area NA2 to the bending area BA and the first non-display area NA1. The plurality of (2-1)-th connection wirings 122a may transmit, to the pixel driving circuit PD of the display area AA, signals transmitted from the flexible circuit board (or flexible film) 157 and the printed circuit board 160 to the pad part PAD.

On the third protective layer 114 a plurality of (2-2)-th connection wirings 122b may be disposed. The plurality of (2-2)-th connection wirings 122b may be disposed in the second non-display area NA2. The (2-2)-th connection wiring 122b may be electrically connected to the (2-1)-th connection wiring 122a through the contact hole in the third protective layer 114. Accordingly, signals from the flexible circuit board (or flexible film) 157 and the printed circuit board 160 can be transmitted to the (2-1)-th connection wiring 122a through the (2-2)-th connection wiring 122b.

On the first insulating layer 115a the (2-3)-th connection wiring 122c may be disposed. The (2-3)-th connection wiring 122c may be disposed in the second non-display area NA2. The (2-3)-th connection wiring 122c may be electrically connected to the (2-2)-th connection wiring 122b through the contact hole in the first insulating layer 115a. Accordingly, signals from the flexible circuit board (or flexible film) 157 and the printed circuit board 160 can be transmitted to the (2-1)-th connection wiring 122a through the (2-3)-th connection wiring 122c and the (2-2)-th connection wiring 122b.

On the second insulating layer 115b the (2-4)-th connection wiring 122d may be disposed. The (2-4)-th connection wiring 122d may be disposed in the second non-display area NA2. The (2-4)-th connection wiring 122d may be electrically connected to the (2-3)-th connection wiring 122c through the contact hole in the second insulating layer 115b. Accordingly, signals from the flexible film (FF) and the printed circuit board 160 can be transmitted to the (2-1)-th connection wiring 122a through the (2-4)-th connection wiring 122d, the (2-3)-th connection wiring 122c and the (2-2)-th connection wiring 122b.

The plurality of first connection wirings 121 and the plurality of second connection wirings 122 may be formed with any one of various conductive materials used in the display area AA or a conductive material having excellent ductility. For example, the second connection wiring 122 whose portion is disposed in the bending area may be configured with a conductive material having excellent ductility, such as gold (Au), silver (Ag), aluminum (Al) or the like, but the embodiments of the present disclosure are not limited thereto. As another example, the plurality of first connection wiring 121 and the plurality of second connection wiring 122 may be configured with molybdenum (Mo), chromium (Cr), titanium (Ti), nickel (Ni), neodymium (Nd), copper (Cu), and an alloy of silver (Ag) and magnesium (Mg), or any alloy thereof, but the embodiments of the present disclosure are not limited thereto.

On a plurality of first connection wirings 121 and a plurality of second connection wirings 122 the third insulating layer 115c may be disposed. The third insulating layer 115c may be disposed in the remaining area except the bending area BA, but the embodiments of the present disclosure are not limited thereto. The third insulating layer 115c may be disposed in the display area AA, the first non-display area NA1, and the second non-display area NA2. A portion of the third insulating layer 115c in the bending area BA may be removed. The third insulating layer 115c may be configured with an organic insulating material, but the embodiments of the present disclosure are not limited thereto. For example, the third insulating layer 115c may be configured with a photo resist, polyimide (PI), or photo acryl-based material, or the like, but the embodiments of the present disclosure are not limited thereto.

On the third insulating layer 115c in the display area AA a plurality of banks BNK may be disposed. The plurality of banks BNK may be disposed to overlap with the plurality of sub-pixels, respectively. On the upper side of each of the plurality of banks BNK one or more light-emitting elements ED of the same kind may be disposed.

On the third insulating layer 115c in the display area AA a plurality of signal wirings TL may be disposed. The plurality of signal wirings TL may be disposed in the area between the plurality of banks BNK. For example, the plurality of signal wirings TL may be disposed adjacent to any one of the plurality of banks BNK.

On the third insulating layer 115c in the display area AA a plurality of contact electrodes CCE can be disposed. The plurality of contact electrodes CCE may supply the cathode voltage from the pixel driving circuit PD to the second electrode CE2.

On the bank BNK the first electrode CE1 may be disposed. For example, the first electrode CE1 may be disposed to extend from the adjacent signal wiring TL toward the upper side of the bank BNK. The first electrode CE1 may be disposed on the upper surface of the bank BNK and on the side surface of the bank BNK. For example, the first electrode CE1 may be disposed to extend from the signal wiring TL on the upper surface of the third insulating layer 115c to the side surface of the bank BNK and the upper surface of the bank BNK.

Referring to FIG. 9, the first electrode CE1 may be configured with a plurality of conductive layers. For example, the first electrode CE1 may include a first conductive layer CE1a, a second conductive layer CE1b, a third conductive layer CE1c, and a fourth conductive layer CE1d, but the embodiments of the present disclosure are not limited thereto.

The first conductive layer CE1a may be disposed on the bank BNK. The second conductive layer CE1b may be disposed on the first conductive layer CE1a. The third conductive layer CE1c may be disposed on the second conductive layer CE1b. The fourth conductive layer CE1d may be disposed on the third conductive layer CE1c. For example, each of the first conductive layer CE1a, the second conductive layer CE1b, the third conductive layer CE1c, and the fourth conductive layer CE1d may be configured with titanium (Ti), molybdenum (Mo), aluminum (Al), titanium (Ti), or indium tin oxide (ITO), but the embodiments of the present disclosure are not limited thereto.

According to the present disclosure, among the plurality of conductive layers constituting the first electrode CE1, some of the conductive layers having good reflection efficiency may be configured as alignment keys and/or reflecting plates for aligning the light-emitting element ED. For example, among the plurality of conductive layers of the first electrode CE1, the second conductive layer CE1b may include a reflective material. For example, the second conductive layer CE1b may include aluminum (Al), but embodiments of the present disclosure are not limited thereto. Accordingly, the second conductive layer CE1b can constitute the reflecting plate. In addition, due to the high reflection efficiency of the second conductive layer CE1b, it can be easily identified during the manufacturing process, and thus the position or transfer position of the light-emitting element ED can be aligned based on the second conductive layer CE1b.

For example, in order to form the second conductive layer CE1b as the reflecting plate, the third conductive layer CE1c and the fourth conductive layer CE1d covering the second conductive layer CE1b may be partially removed or etched. For example, a portion of the third conductive layer CE1c and the fourth conductive layer CE1d disposed on the bank BNK may be removed or etched to expose the upper surface of the second conductive layer CE1b. For example, the central portion and the border portion or edge portion of the third conductive layer CE1c and the fourth conductive layer CE1d may be left, and the remaining portion may be removed, wherein the solder pattern SDP is placed on the central portion. For example, the border portion or edge portion of each of the third conductive layer CE1c configured with titanium (Ti) and the fourth conductive layer CE1d configured with indium tin oxide (ITO) may not be etched. Accordingly, it is possible to prevent other conductive layers of the first electrode CE1 from being corroded by the tetramethylammonium hydroxide (TMAH) solution used in the mask process of the first electrode CE1.

According to the present disclosure, the first conductive layer CE1a and the third conductive layer CE1c may include titanium (Ti) or molybdenum (Mo). The second conductive layer CE1b may include aluminum (Al). The fourth conductive layer CE1d may include a transparent conductive oxide layer, such as indium tin oxide (ITO) or indium zinc oxide (IZO), which has good adhesion to the solder pattern SDP and has corrosion resistance and acid resistance. However, the embodiments of the present disclosure are not limited thereto.

The first conductive layer CE1a, the second conductive layer CE1b, the third conductive layer CE1c, and the fourth conductive layer CE1d can be sequentially deposited and then patterned by performing a photolithography process and an etching process, but the embodiments of the present disclosure are not limited thereto.

According to the present disclosure, the signal wiring TL, the contact electrode CCE, and the pad electrode PE disposed on the same layer as the first electrode CE1 may be configured in a multi-layer structure of conductive materials, but the embodiments of the present disclosure are not limited thereto. For example, the signal wiring TL, contact electrode CCE, and pad electrode PE may be formed in a multi-layer structure of indium tin oxide (ITO)/titanium (Ti)/aluminum (Al)/titanium (Ti), but the embodiments of the present disclosure are not limited thereto.

According to the present disclosure, the solder pattern SDP may be disposed on the first electrode CE1 in each of the plurality of sub-pixels. A solder pattern SDP may bond the light-emitting element ED to the first electrode CE1. The first electrode CE1 and the light-emitting element ED may be electrically connected through eutectic bonding using the solder pattern SDP, but the embodiments of the present disclosure are not limited thereto. For example, in a case where the solder pattern SDP is configured with indium (In) and the anode electrode 134 of the light-emitting element ED is configured with gold (Au), the solder pattern SDP and the anode electrode 134 may be joined by applying heat and pressure during the transfer process of the light-emitting element ED. Through the eutectic bonding, the light-emitting element ED can be bonded to the solder pattern SDP and the first electrode CE1 without a separate adhesive material. For example, the solder pattern SDP may be configured with indium (In), tin (Sn) or alloys thereof, but embodiments of the present disclosure are not limited thereto. For example, the solder pattern SDP may be a bonding pad or a joining pad, but the embodiments of the present disclosure are not limited thereto.

According to the present disclosure, on the plurality of signal wirings TL, the plurality of first electrodes CE1, the plurality of contact electrodes CCE, and the third insulating layer 115c a passivation layer 116 may be disposed. For example, the passivation layer 116 may be disposed in the display area AA, the first non-display area NA1, and the second non-display area NA2. A portion of the passivation layer 116 disposed in the bending area BA may be removed. A portion of the passivation layer 116 covering the plurality of pad electrodes PE in the second non-display area NA2 may be removed. The passivation layer 116 may be disposed to cover the remaining area except the bending area BA, the plurality of pad electrodes PE, and the area where the solder pattern SDP is disposed, thus capable of reducing the penetration of moisture or impurities into the light-emitting element ED. For example, the passivation layer 116 may be configured in a single-layer or multi-layer structure of silicon oxide (SiOx) or silicon nitride (SiNx), but the embodiments of the present disclosure are not limited thereto. For example, the passivation layer 116 may be a protective layer or an insulating layer, but the embodiments of the present disclosure are not limited thereto. For example, the passivation layer 116 may include a hole through which the solder pattern SDP is exposed.

In each of the plurality of sub-pixels, the light-emitting element ED may be disposed on the solder pattern SDP. In the first sub-pixel SP1 the first light-emitting element 130 may be disposed. In the second sub-pixel SP2 the second light-emitting element 140 may be disposed. In the third sub-pixel SP3 the third light-emitting element 150 may be disposed.

The light-emitting element ED may be formed on a silicon wafer by a method such as metal organic chemical vapor deposition (MOCVD), chemical vapor deposition (CVD), plasma-enhanced chemical vapor deposition (PECVD), molecular beam epitaxy (MBE), hydride vapor phase epitaxy (HVPE), sputtering, or the like, but the embodiments of the present disclosure are not limited thereto.

Referring to FIG. 9, the first light-emitting element 130 may include the anode electrode 134, a first semiconductor layer 131, an active layer 132, a second semiconductor layer 133, a cathode electrode 135, and a sealing film 136, but the embodiments of the present disclosure are not limited thereto. For example, the first light-emitting element 130 may not include the sealing film 136.

On a solder pattern SDP the first semiconductor layer 131 may be disposed. On the first semiconductor layer 131 the second semiconductor layer 133 may be disposed.

For example, one of the first semiconductor layer 131 and the second semiconductor layer 133 may be implemented as a compound semiconductor of group III-V, group II-VI, or the like, and may be doped with an impurity or dopant. For example, one of the first semiconductor layer 131 and the second semiconductor layer 133 may be a semiconductor layer doped with an n-type impurity, and the other thereof may be a semiconductor layer doped with a p-type impurity, but the embodiments of the present disclosure are not limited thereto. For example, one of the first semiconductor layer 131 and the second semiconductor layer 133 may be a layer where an n-type or p-type impurity is doped in a material such as gallium nitride (GaN), gallium phosphide (GaP), gallium arsenide phosphide (GaAsP), aluminum gallium indium phosphide (AlGaInP), indium aluminum phosphide (InAIP), aluminum gallium nitride (AlGaN), aluminum indium nitride (AllnN), aluminum indium gallium nitride (AllnGaN), aluminum gallium arsenide (AlGaAs), or gallium arsenide (GaAs), but the embodiments of the present disclosure are not limited thereto. For example, the n-type impurity may be silicon (Si), germanium (Ge), selenium (Se), carbon (C), tellurium (Te), tin (Sn), or the like, but the embodiments of the present disclosure are not limited thereto. For example, the p-type impurity may be magnesium (Mg), zinc (Zn), calcium (Ca), strontium (Sr), barium (Ba), beryllium (Be), or the like, but the embodiments of the present disclosure are not limited thereto.

For example, the first semiconductor layer 131 and the second semiconductor layer 133 may be a nitride semiconductor containing an n-type impurity and a nitride semiconductor containing a p-type impurity, respectively, but the embodiments of the present disclosure are not limited thereto. For example, the first semiconductor layer 131 may be a nitride semiconductor containing a p-type impurity, and the second semiconductor layer 133 may be a nitride semiconductor containing an n-type impurity, but the embodiments of the present disclosure are not limited thereto.

The active layer 132 may be disposed between the first semiconductor layer 131 and the second semiconductor layer 133. The active layer 132 may emit light by receiving holes and electrons from the first semiconductor layer 131 and the second semiconductor layer 133. For example, the active layer 132 may be configured in one of a single well structure, a multi-well structure, a single quantum well structure, a multi-quantum well (MQW) structure, a quantum dot structure, and a quantum wiring structure, but the embodiments of the present disclosure are not limited thereto. For example, the active layer 132 may be composed of indium gallium nitride (InGaN) or gallium nitride (GaN), but the embodiments of the present disclosure are not limited thereto.

As another example, the active layer 132 may include a multi-quantum well (MQW) structure having a well layer and a barrier layer having a higher band gap than the well layer. For example, the active layer 132 may be composed of InGaN layer as a well layer and an AlGaN layer as a barrier layer, but the embodiments of the present disclosure are not limited thereto.

The anode electrode 134 may be disposed between the first semiconductor layer 131 and the solder pattern SDP. For example, the anode electrode 134 may electrically connect the first semiconductor layer 131 with the first electrode CE1. The anode voltage output from the pixel driving circuit PD may be applied to the first semiconductor layer 131 through the signal wiring TL, the first electrode CE1, and the anode electrode 134. For example, the anode electrode 134 may be composed of a conductive material capable of eutectic bonding with the solder pattern SDP, but the embodiments of the present disclosure are not limited thereto. For example, the anode electrode 134 may be composed of gold (Au), tin (Sn), tungsten (W), silicon (Si), silver (Ag), titanium (Ti), iridium (Ir), chromium (Cr), indium (In), zinc (Zn), lead (Pb), nickel (Ni), platinum (Pt), copper (Cu), or any alloy thereof, but the embodiments of the present disclosure are not limited thereto.

The cathode electrode 135 may be disposed on the second semiconductor layer 133. For example, the cathode electrode 135 may electrically connect the second semiconductor layer 133 with the second electrode CE2. The cathode voltage output from the pixel driving circuit PD may be applied to the second semiconductor layer 133 through the contact electrode CCE, the second electrode CE2, and the cathode electrode 135. The cathode electrode 135 may be composed of a transparent conductive material so that light emitted from the light-emitting element ED can be directed to the upper side of the light-emitting element ED, but the embodiments of the present disclosure are not limited thereto. For example, the cathode electrode 135 may be configured with a material such as indium tin oxide (ITO), indium zinc oxide (IZO), indium gallium zinc oxide (IGZO), or the like, but the embodiments of the present disclosure are not limited thereto.

The sealing film 136 may be disposed on at least a portion of the first semiconductor layer 131, the active layer 132, the second semiconductor layer 133, the anode electrode 134, and the cathode electrode 135. For example, the sealing film 136 may surround at least a portion of the first semiconductor layer 131, the active layer 132, the second semiconductor layer 133, the anode electrode 134, and the cathode electrode 135.

For example, the sealing film 136 may protect the first semiconductor layer 131, the active layer 132, and the second semiconductor layer 133. For example, the sealing film 136 can be disposed on the side surface of the first semiconductor layer 131, the side surface of the active layer 132, and the side surface of the second semiconductor layer 133.

For example, the sealing film 136 may be disposed on at least a portion of the anode electrode 134 and the cathode electrode 135, for example, an edge portion or a border portion or one side of the anode electrode 134 and an edge portion or a border portion or one side of the cathode electrode 135. At least a portion of the anode electrode 134 may be exposed from the sealing film 136 so that the anode electrode 134 and the solder pattern SDP can be connected to each other. For example, at least a portion of the cathode electrode 135 may be exposed from the sealing film 136 so that the cathode electrode 135 and the second electrode CE2 can be connected to each other. For example, the sealing film 136 may be configured with an insulating material such as silicon nitride (SiNx) or silicon oxide (SiOx), but the embodiments of the present disclosure are not limited thereto.

As another example, the sealing film 136 may be configured as a resin layer in which a reflective material is dispersed, but the embodiments of the present disclosure are not limited thereto. For example, the sealing film 136 may be manufactured as a reflector having various structures, but the embodiments of the present disclosure are not limited thereto. Light emitted from the active layer 132 can be reflected to the upper side by the sealing film 136, so that light extraction efficiency can be improved. For example, the sealing film 136 may be a reflective layer, but the embodiments of the present disclosure are not limited thereto.

According to the present disclosure, the light-emitting element ED is described as having a vertical structure, but the embodiments of the present disclosure are not limited thereto. For example, the light-emitting element ED may have a lateral structure or a flip chip structure.

Although the first light-emitting element 130 has been described with reference to FIG. 9, the second light-emitting element 140 and the third light-emitting element 150 may have structures substantially identical to that of the first light-emitting element 130. For example, the second light-emitting element 140 and the third light-emitting element 150 may be substantially identical to the first semiconductor layer 131, the active layer 132, the second semiconductor layer 133, the anode electrode 134, the cathode electrode 135, and the sealing film 136 of the first light-emitting element 130.

According to the present disclosure, in the display area AA, there may be disposed a first optical layer 117a surrounding a plurality of light-emitting elements ED. For example, the first optical layer 117a may be disposed to cover a plurality of light-emitting elements ED and banks BNK in the areas of a plurality of sub-pixels. For example, the first optical layer 117a may cover the bank BNK, a portion of the passivation layer 116, and a gap between a plurality of light-emitting elements ED. The first optical layer 117a may cover or be disposed between a plurality of light-emitting elements ED and between a plurality of banks BNK included in one pixel PX. For example, the first optical layers 117a may extend in a first direction (X) and be spaced apart from each other in the second direction (Y). For example, the first optical layer 117a may be disposed to surround the side portion of the bank BNK and the light-emitting element ED between the passivation layer 116 and the second electrode CE2, but the embodiments of the present disclosure are not limited thereto. For example, the first optical layer 117a may be a diffusion layer or a sidewall diffusion layer, but the embodiments of the present disclosure are not limited thereto.

The first optical layer 117a may include an organic insulating material having fine particles dispersed therein, but the embodiments of the present disclosure are not limited thereto. For example, the first optical layer 117a may be composed of siloxane having fine particles such as titanium dioxide (TiO₂) particles dispersed therein, but the embodiments of the present disclosure are not limited thereto. Light from the plurality of light-emitting elements ED may be scattered by fine particles dispersed in the first optical layer 117a and emitted to the outside of the display device 1000. Accordingly, the first optical layer 117a can improve the extraction efficiency of light emitted from the plurality of light-emitting elements ED.

For example, the first optical layer 117a may be disposed in each of the plurality of pixels PX or may be disposed commonly for some of the pixels PX disposed in the same row, but the embodiments of the present disclosure are not limited thereto. For example, the first optical layer 117a may be disposed in each of a plurality of pixels PX, or a plurality of pixels PX may share one first optical layer 117a. As another example, each of the plurality of sub-pixels may separately include a first optical layer 117a, but the embodiments of the present disclosure are not limited thereto.

According to the present disclosure, on the passivation layer 116 in the display area AA a second optical layer 117b may be disposed. For example, the second optical layer 117b may be disposed to surround the first optical layer 117a. For example, the second optical layer 117b may be in contact with a side surface of the first optical layer 117a thereby surrounding the side surface of the first optical layer 117a. For example, the second optical layer 117b may be disposed in an area between a plurality of pixels PX. However, the embodiments of the present disclosure are not limited thereto. For example, the second optical layer 117b may be a diffusion layer, a diffusion layer window, a window diffusion layer, or the like, but the embodiments of the present disclosure are not limited thereto.

The second optical layer 117b may be composed of an organic insulating material, but the embodiments of the present disclosure are not limited thereto. The second optical layer 117b may be composed of the same material as the first optical layer 117a, but the embodiments of the present disclosure are not limited thereto. For example, the first optical layer 117a may include fine particles, and the second optical layer 117b may not include fine particles. For example, the second optical layer 117b may be configured with siloxane, but the embodiments of the present disclosure are not limited thereto.

For example, the thickness of the first optical layer 117a may be smaller than the thickness of the second optical layer 117b, but the embodiments of the present disclosure are not limited thereto. Accordingly, when viewed in a cross-sectional view, the area where the first optical layer 117a is disposed may include a concave portion that is recessed inward more than the upper surface of the second optical layer 117b.

According to the present disclosure, the second electrode CE2 may be disposed on the first optical layer 117a and the second optical layer 117b. For example, the second electrode CE2 may be electrically connected to the plurality of contact electrodes CCE through contact holes in the second optical layer 117b. For example, the second electrode CE2 may be disposed on a plurality of light-emitting elements ED. For example, the second electrode CE2 may include a transparent conductive oxide such as indium tin oxide (ITO) or indium zinc oxide (IZO), but the embodiments of the present disclosure are not limited thereto. For example, the second electrode CE2 may be disposed in contact with the cathode electrode 135. For example, the second electrode CE2 may overlap with the first optical layer 117a. For example, it may cover the upper surface of the first optical layer 117a.

The second electrode CE2 may extend continuously in the first direction of the substrate 110. Accordingly, it can be commonly connected to a plurality of pixels PX arranged in the first direction of the substrate 110. For example, the second electrode CE2 may be commonly connected to a plurality of pixels PX.

According to the present disclosure, the second electrode CE2 may extend continuously over the first optical layer 117a, the second optical layer 117b, and the light-emitting element ED. The area where the first optical layer 117a is disposed may include a concave portion that is recessed inward more than the upper surface of the second optical layer 117b. Accordingly, a first portion of the second electrode CE2 disposed on the first optical layer 117a is disposed along the concave portion, and thus can be disposed at a lower position than a second portion of the second electrode CE2 disposed on the second optical layer 117b.

On the second electrode CE2 a third optical layer 117c may be disposed. The third optical layer 117c may be disposed to overlap with the plurality of light-emitting elements ED and the first optical layer 117a. For example, the third optical layer 117c is on an upper surface of the first optical layer 117a thereby overlapping the upper surface of the first optical layer 117a. The third optical layer 117c is between a portion of a black matrix BM and the first optical layer 117a. Since the third optical layer 117c is disposed on the second electrode CE2 and the plurality of light-emitting elements ED, it is possible to alleviate stains Mura that may occur on some of the plurality of light-emitting elements ED. For example, when transferring the plurality of light-emitting elements ED onto the substrate 110 of the display device 1000, its process deviation or the like may cause the occurrence of an area where the spacings between the plurality of light-emitting elements ED are not uniform. If the spacings between the plurality of light-emitting elements ED are uneven, the emission areas of the plurality of respective light-emitting elements ED may be disposed unevenly, which may, in turn, cause stains Mura to be visible to the user. To address this, the third optical layer 117c is constructed over the plurality of light-emitting elements ED so as to be configured to uniformly diffuse light over, and thus it is possible to alleviate the phenomenon in which light emitted from some light-emitting elements ED looks like stains. Accordingly, since the light emitted from the plurality of light-emitting elements ED is evenly diffused by the third optical layer 117c and extracted to the outside of the display device 1000, the brightness uniformity of the display device 1000 can be improved.

The third optical layer 117c may be composed of an organic insulating material having fine particles dispersed therein, but the embodiments of the present disclosure are not limited thereto. For example, the third optical layer 117c may be composed of siloxane having fine particles such as titanium dioxide (TiO₂) particles dispersed therein, but the embodiments of the present disclosure are not limited thereto. For example, the third optical layer 117c may be composed of the same material as the first optical layer 117a, but the embodiments of the present disclosure are not limited thereto. For example, the third optical layer 117c may be a diffusion layer or an upper surface diffusion layer, but the embodiments of the present disclosure are not limited thereto.

The refractive index of the third optical layer 117c may range from 1.50 to 1.55. In one example, the refractive index of the third optical layer 117c may be 1.53.

According to the present disclosure, light from a plurality of light-emitting elements ED can be emitted to the outside of the display device 1000 in a state of being scattered by fine particles dispersed in the third optical layer 117c. The third optical layer 117c can evenly mix the lights emitted from the plurality of light-emitting elements ED to further improve the brightness uniformity of the display device 1000. Furthermore, the light extraction efficiency of the display device 1000 can be improved by the light being scattered by the plurality of fine particles, thereby enabling the display device 1000 to be driven at low power.

On the second electrode CE2, the first optical layer 117a, the second optical layer 117b, and the third optical layer 117c in the display area AA, there may be disposed a black matrix BM. For example, the black matrix BM may fill the contact hole in the second optical layer 117b. The black matrix BM may be formed to cover the display area AA, so that color mixing of light from a plurality of sub-pixels and external light reflection can be reduced. For example, since the black matrix BM may be disposed within the contact hole where the second electrode CE2 and the contact electrode CCE are connected to each other, light leakage between neighboring sub-pixels can be prevented.

For example, the black matrix BM may be composed of an opaque material, but the embodiments of the present disclosure are not limited thereto. For example, the black matrix BM may be an organic insulating material having black pigment or black dye added thereto, but the embodiments of the present disclosure are not limited thereto.

On the black matrix BM in the display area AA a cover layer 118 may be disposed. The cover layer 118 can protect the configuration under the cover layer 118. For example, the cover layer 118 may be composed of an organic insulating material, but the embodiments of the present disclosure are not limited thereto. For example, the cover layer 118 may be configured with a photo resist, polyimide (PI), or photo acryl-based material, or the like, but the embodiments of the present disclosure are not limited thereto. For example, the cover layer 118 may be an overcoating layer or an insulating layer, but the embodiments of the present disclosure are not limited thereto.

On the cover layer 118 the polarizing layer 293 may be disposed via a first adhesive layer 291. On the polarizing layer 293 the cover member 155 may be disposed via the adhesive layer 295 (hereinafter, it may also be referred to as a second adhesive layer 295). For example, the first adhesive layer 291 and the second adhesive layer 295 may include an optically clear adhesive (OCA), an optically clear resin (OCR), or a pressure sensitive adhesive (PSA), but the embodiments of the present disclosure are not limited thereto.

According to the present disclosure, on the third insulating layer 115c in the second non-display area NA2 the plurality of pad electrodes PE may be disposed. For example, at least a portion of the plurality of pad electrodes PE may be exposed from the passivation layer 116. For example, a plurality of pad electrodes PE may be electrically connected to the (2-4)-th connection wiring 122d through the contact hole in the third insulating layer 115c.

An adhesive layer ACF may be disposed on the plurality of pad electrodes PE. The adhesive layer ACF may be an adhesive layer in which conductive balls are dispersed in an insulating material, but the embodiments of the present disclosure are not limited thereto. In a case where heat or pressure is applied to the adhesive layer ACF, the conductive balls can be electrically connected in the part where the heat or pressure is applied, thereby providing conductive property. By placing the adhesive layer ACF between a plurality of pad electrodes PE and the flexible circuit board (or flexible film) 157, the flexible circuit board (or flexible film) 157 can be attached or bonded to a plurality of pad electrodes PE. For example, the adhesive layer ACF may be an anisotropic conductive film ACF, but the embodiments of the present disclosure are not limited thereto.

On the adhesive layer ACF the flexible circuit board (or flexible film) 157 may be disposed. The flexible circuit board (or flexible film) 157 may be electrically connected to the plurality of pad electrodes PE through the adhesive layer ACF. Accordingly, signals output from the flexible circuit board (or flexible film) 157 and the printed circuit board can be transmitted to the pixel driving circuit PD in the display area AA through the plurality of pad electrodes PE, the (2-4)-th connection wiring 122d, the (2-3)-th connection wiring 122c, the (2-2)-th connection wiring 122b, and the (2-1)-th connection wiring 122a.

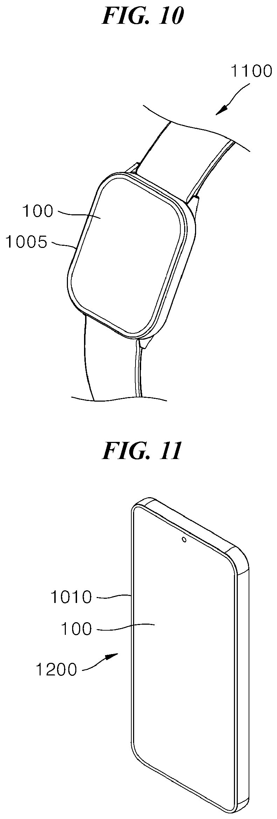

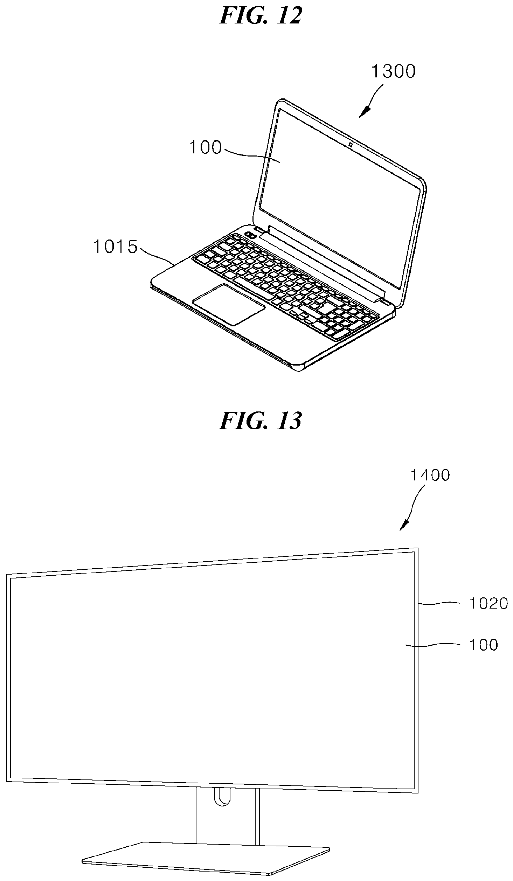

FIGS. 10 to 13 are views illustrating devices to which display devices according to embodiments of the present disclosure are applied.

Referring to FIGS. 10 to 13, the display device 1000 according to the embodiments of the present disclosure may be included in various devices or electronic devices. For example, referring to FIGS. 10 to 13, various electronic devices may include a wearable device 1100, a mobile device 1200, a notebook 1300, and a monitor or TV 1400, but the embodiments of the present disclosure are not limited thereto.

Each of the wearable device 1100, the mobile device 1200, the notebook 1300, and the monitor or TV 1400 may respectively include a case 1005, 1010, 1015, 1020, and the display panel 100 (or the display device 1000) according to the embodiment of the present disclosure described with reference to FIGS. 1 to 9.

For example, the display device according to the embodiment of the present disclosure may be applied to a mobile device, a video phone, a smart watch, a watch phone, a wearable device, a foldable device, a rollable device, a bendable device, a flexible device, a curved device, a sliding device, a variable device, an electronic notebook, an electronic book, a portable multimedia player (PMP), a personal digital assistant (PDA), an MP3 player, a mobile medical device, a desktop PC, a laptop PC, a netbook computer, a workstation, a navigation system, a vehicle display device, a theater display device, a television, a wallpaper device, a signage device, a game device, a notebook, a monitor, a camera, a camcorder, home appliances, or the like.

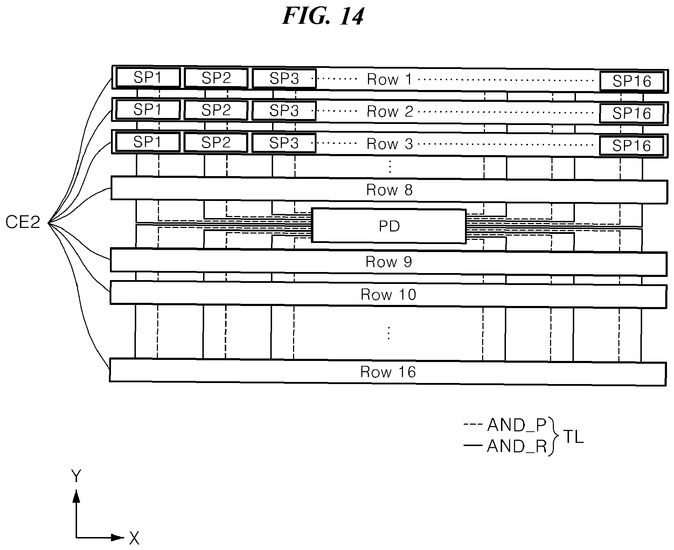

FIG. 14 is a plan view showing an area where one pixel driving circuit of a plurality of pixel driving circuits is arranged.

Referring to FIGS. 3, 5 and 14 together, one pixel driving circuit PD may be electrically connected to a plurality of signal wirings TL that are electrically connected to a plurality of sub-pixels. A plurality of sub-pixels may include a plurality of light-emitting elements ED (see FIG. 3) disposed in the same column direction SP1, SP2, SP3, ..., SP16 and the same row direction Row 1, Row 2, Row 3, ..., Row 16.

Between the plurality of sub-pixels the plurality of signal wirings TL extending in the column direction may be disposed. The plurality of signal wirings TL may include a first line AND_P and a second line AND_R. The first line AND_P and the second line AND_R may be disposed to be spaced apart from each other in the first direction X, which is the row direction. Each of the first line AND_P and the second line AND_R may be electrically connected to a pair of sub-pixels, respectively. The pair of sub-pixels may each have a light-emitting element ED disposed thereon. One of the light-emitting elements ED may be a main light-emitting element, and the other one thereof may be a redundant light-emitting element. For example, referring to FIG. 5, the (1-1)-th light-emitting element 130a, the (2-1)-th light-emitting element 140a, and the (3-1)-th light-emitting element 150a transferred to one pixel PX may be main light-emitting elements ED. Additionally, the (1-2)-th light-emitting element 130b, the (2-2)-th light-emitting element 140b, and the (3-2)-th light-emitting element 150b may be redundant light-emitting elements ED.

The first line AND_P may correspond to a signal wiring disposed in an odd number column. For example, referring to FIGS. 5 and 14 together, the first line AND_P may correspond to a first signal wiring TL1, a third signal wiring TL3, and a fifth signal wiring TL5. The second line AND_R may correspond to a signal wiring disposed in an even number column. For example, the second line AND_R may correspond to a second signal wiring TL2, a fourth signal wiring TL4, and a sixth signal wiring TL6. The first line AND_P and the second line AND_R may be referred to as a signal wiring.

The plurality of second electrodes CE2 may be disposed to extend in the row direction. The plurality of second electrodes CE2 may be disposed to be spaced apart from each other in the second direction Y which is the column direction.

The plurality of signal wirings TL may be radially connected with at least one pixel driving circuit PD to connect the first sub-pixel SP1 disposed at a first position in the first row Row 1 and the sixteenth sub-pixel SP16 disposed at a sixteenth position opposite to the first sub-pixel SP1 with the pixel driving circuit PD, respectively. For example, a shape in which the plurality of signal wirings TL are connected may be a rhombus shape or an 'I' shape when viewed from a plan view.

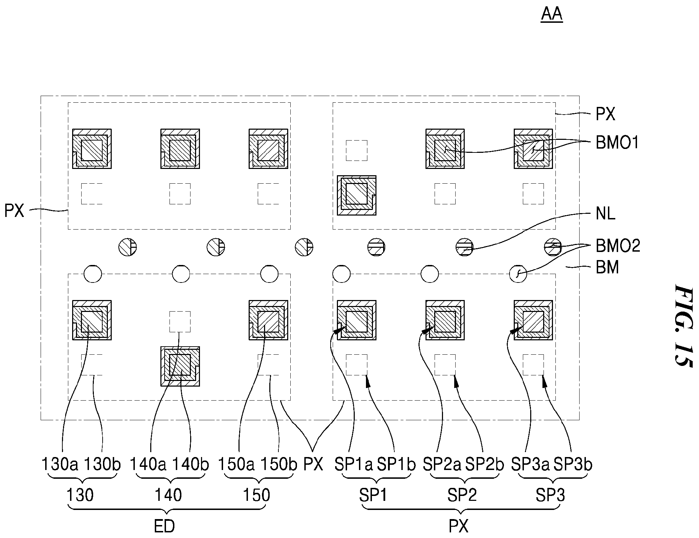

FIG. 15 is a plan view of a display device having a black matrix disposed therein according to an embodiment of the present disclosure.

Referring to FIGS. 7, 8, and 15 together, a black matrix BM may be disposed on the second electrode CE2, the first optical layer 117a, the second optical layer 117b, and the third optical layer 117c in the display area AA.

The black matrix BM can prevent or at least reduce color mixing between the sub-pixels SP1, SP2, SP3 in one pixel PX, which are provided with the plurality of light-emitting elements ED emitting lights of different colors.

Additionally, the black matrix BM can define emission areas of lights emitted from a plurality of light-emitting elements ED. For example, the black matrix BM may include a plurality of opening holes BMO1, BMO2. The plurality of opening holes BMO1, BMO2 may include a plurality of first opening holes BMO1 and a plurality of second opening holes BMO2. The first opening hole BMO1 may be disposed to correspond to each of the light-emitting elements ED on the first sub-pixel SP1, the second sub-pixel SP2, and the third sub-pixel SP3. In one embodiment, each first opening hole BMO1 overlaps a corresponding light-emitting element from one of the first sub-pixel SP1, the second sub-pixel SP2, or the third sub-pixel SP3.

On each of the first sub-pixel SP1, the second sub-pixel SP2, and the third sub-pixel SP3, there may be disposed a pair of light-emitting elements ED. The pair of light-emitting elements ED may include a main light-emitting element ED and a redundant light-emitting element ED. For example, the (1-1)-th light-emitting element 130a, the (2-1)-th light-emitting element 140a, and the (3-1)-th light-emitting element 150a may be main light-emitting elements ED. Additionally, the (1-2)-th light-emitting element 130b, the (2-2)-th light-emitting element 140b, and the (3-2)-th light-emitting element 150b may be redundant light-emitting elements ED.

The first opening hole BMO1 may expose one light-emitting element ED among a pair of light-emitting elements ED disposed in one sub-pixel, which has been determined to be normal. That is, the first opening hole BMO1 overlaps a light-emitting element ED from the pair of light-emitting elements ED that is functional (e.g., emits light) but is non-overlapping with a light-emitting element ED from the pair of light-emitting elements ED that is defective because it cannot emit light. As a result, the black matrix BM covers or overlaps the defective light-emitting element ED.

For example, an inspection may be performed with regard to whether there is a defect in one first sub-pixel SP1 configured with a (1-1)-th sub-pixel SP1a in which a (1-1)-th light-emitting element 130a is disposed and a (1-2)-th sub-pixel SP1b in which a (1-2)-th light-emitting element 130b is arranged. If both the (1-1)-th light-emitting element 130a and the (1-2)-th light-emitting element 130b are determined to be normal in the defect inspection, the first opening hole BMO1 may be disposed to correspond to the (1-1)-th light-emitting element 130a, which is the main light-emitting element while the (1-2)-th light-emitting element 130b may be covered with the black matrix BM.

In another example, if the (1-2)-th light-emitting element 130b among the (1-1)-th light-emitting element 130a and the (1-2)-th light-emitting element 130b is determined to be normal, the first opening hole BMO1 may be disposed to correspond to the (1-2)-th light-emitting element 130b, which is the redundant light-emitting element. The (1-1)-th light-emitting element 130a may be covered with the black matrix BM so as not to be exposed to the outside.

Accordingly, the first opening hole BMO1 can define a light-emitting area. The first opening hole BMO1 may have an area greater than that of each light-emitting element ED. That is, an area of the first opening hole BMO1 is greater than an area of a light-emitting element that is overlapped by the first opening hole BMO1.

The second opening hole BMO2 may be disposed between neighboring pixels PX. For example, between pixels PX disposed neighboring to each other in the column direction, there may be disposed a plurality of communication wirings NL. The plurality of communication lines NL may be disposed to extend in the row direction. The second opening hole BMO2 may be disposed to correspond to at least a portion of the plurality of communication wires NL. That is, the second opening hole BMO2 overlaps at least a portion of the communication wires NL. The plurality of communication wires NL may be exposed through the second opening hole BMO2 to function as an antenna for short-range communication such as, but not limited to, NFC (Near Field Communication).

On the black matrix BM in the display area AA, there may be disposed a cover layer 118 protecting the lower side configuration. The cover layer 118 may include an organic insulating material. For example, the cover layer 118 may be configured with photo resist, polyimide (PI), photo acryl-based material, or the like; however, this is not exhaustive.

On the cover layer 118 the polarizing layer 293 may be disposed via a first adhesive layer 291. On the polarizing layer 293 the cover member 155 may be disposed via a second adhesive layer 295.

The polarizing layer 293 can improve the visibility of the display device by preventing or reducing internal reflection of light generated from an external light source by metal wiring inside the display panel 100.

For example, the polarizing layer 293 may include an optical absorption axis along which light is absorbed. Among the lights incident to the polarizing layer 293 from a light source, a light vibrating in a direction parallel to the light absorption axis can be absorbed therein, and a light vibrating in a direction perpendicular to the light absorption axis can transmit through the polarizing layer 293. For example, the polarizing layer 293 may be configured with at least one of poly-vinyl alcohol (PVA), tri-acetyl cellulose (TAC), acrylate, and cyclo olefin copolymer (COP).

Meanwhile, the polarizing layer 293 has a transmittance of 50%, which is difficult to change. Accordingly, the light emitted from the light-emitting element ED may have its brightness reduced as it is emitted through the polarizing layer 293 at a fixed transmittance of 50%. As the brightness of the light decreases, the power consumption for achieving the same brightness increases, which may thus decrease the light extraction efficiency.

In addition, since the polarizing layer 293 is constructed in a multilayer structure including a protective film that protects the polarizing layer 293, a phase difference layer, there is a limit to reducing the overall thickness of the polarizing layer 293. Accordingly, there are difficulties in applying it to variable display devices such as foldable display devices, flexible display devices, or bendable display devices, which need to be implemented in a thin thickness.

Another embodiment of the present disclosure includes a configuration in which the transmittance can be adjusted by omitting the polarizing layer.

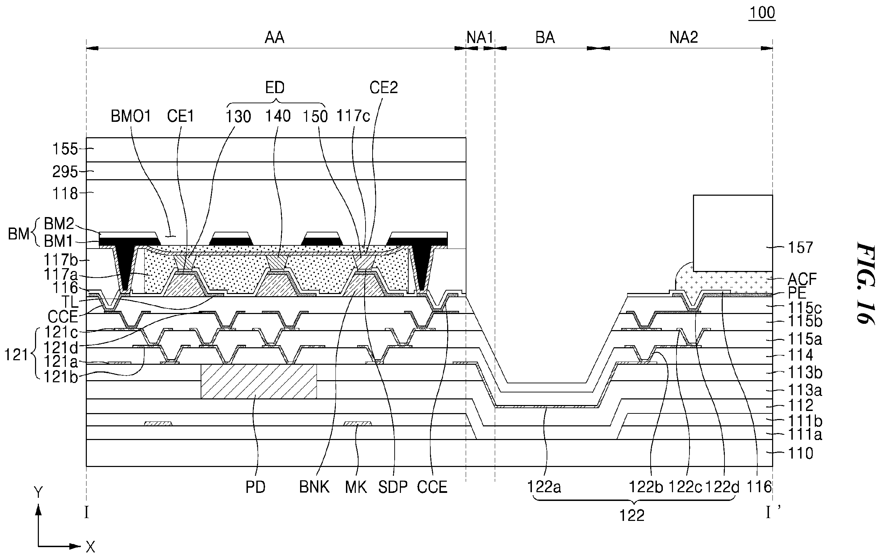

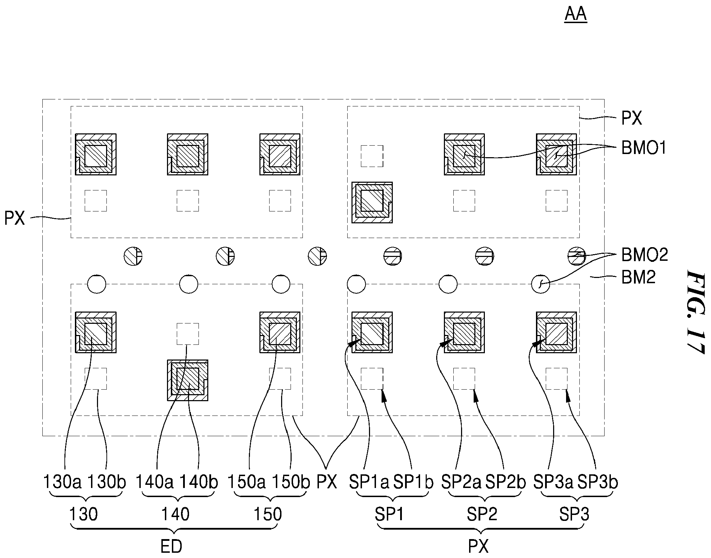

FIG. 16 is a cross-sectional view of a display device according to another embodiment of the present disclosure. FIG. 17 is a plan view of a display device according to another embodiment of the present disclosure. For example, FIG. 16 is a cross-sectional view taken along line I-I' of FIG. 2.

In FIGS. 16 and 17, the same reference numerals will be given to the same components as those in FIG. 15 described with reference to FIG. 8, and the description thereof will be simplified or omitted.

Referring to FIGS. 16 and 17, on the second electrode CE2, the first optical layer 117a, the second optical layer 117b, and the third optical layer 117c in the display area AA, there may be disposed a black matrix BM.

The black matrix BM may have a multilayer structure of at least two layers. For example, the black matrix BM may include a first black matrix BM1 and a second black matrix BM2 on the first black matrix BM1.

The first black matrix BM1 may be disposed at the lower side of the multilayer black matrix BM structure. The first black matrix BM1 may fill the contact hole in the second optical layer 117b. The first black matrix BM1 may be disposed between the sub-pixels SP1, SP2, SP3 in which a plurality of light-emitting elements ED are disposed, and between neighboring pixels PX.

The first black matrix BM1 may be configured with an opaque material. For example, the first black matrix BM1 may be an organic insulating material with black material such as black pigment or black dye added to the organic insulating material. In one example, the black pigment or black dye may include, but is not limited to, carbon black particles.

An optical density (Optical Density, O.D) indicating the degree of light blocking for the first black matrix BM1 may be a first optical density O.D1. For example, the first optical density O.D1 of the first black matrix BM1 may be greater than 3.0 at a thickness of 1 micrometer (µm) (O.D1>3.0). In one example, the first optical density O.D1 of the first black matrix BM1 may be, but is not limited to, 4.0 at a thickness of 1 micrometer. For example, the first optical density O.D1 of the first black matrix BM1 may be greater than 3.0 and less than or equal to 4.0. The first black matrix BM1 may have a thickness not larger than 1 µm on the upper surface of the third optical layer 117c. However, this is not exhaustive.

The optical density may increase or decrease depending on the content of carbon black particles contained in the organic insulating material. However, if the optical density becomes excessively high, the permittivity increases, which may incur a leakage current to adjacent sub-pixels. Accordingly, the first optical density O.D1 of the first black matrix may be 4.0 or less at a thickness of 1 micrometer.

The second black matrix BM2 may be disposed on the first black matrix BM1. In one embodiment, the second black matrix BM2 is in contact with an upper surface of the first black matrix BM1. The second black matrix BM2 may have at least the same area as the first black matrix BM1. The second black matrix BM2 may be configured with a translucent material. For example, the second black matrix BM2 may be an organic insulating material with black pigment or black dye added thereto. In one example, the black pigment or black dye may include, but is not limited to, carbon black particles. For example, the second black matrix BM2 may be an organic insulating material including carbon black particles that are dispersed in the organic insulating material.

An optical density indicating the degree of light blocking for the second black matrix BM2 may be a second optical density O.D2. The second optical density O.D2 of the second black matrix BM2 may be less than the first optical density O.D1 (O.D2<O.D1). For example, the second optical density O.D2 of the second black matrix BM2 may be 3.0 or less at a thickness of 1 micrometer (µm) (O.D2:53.0). For example, the second optical density O.D2 of the second black matrix BM2 may be greater than 0.

The second black matrix BM2 can reduce the reflectivity of external light. Therefore, the lower the optical density (O.D) value of the second black matrix BM2 is the better to reduce reflectivity. For this purpose, the second optical density O.D2 of the second black matrix BM2 may be less than the first optical density O.D1. Thus, the second black matrix BM2 may be considered a reflectivity reduction layer in one embodiment.

As the second black matrix BM2 reduces the reflectivity related to an external light source, the internal reflection by the metal wirings or the like inside the display panel 100 can be reduced, thereby improving the visibility of the display device.

The black matrix BM including the first black matrix BM1 and the second black matrix BM2 may include a plurality of opening holes BMO1, BMO2. The black matrix BM may include a first opening hole BMO1 and a second opening hole BMO2. The first opening hole BMO1 and the second opening hole BMO2 can each penetrate through the first black matrix BM1 and the second black matrix BM2.

The first opening hole BMO1 may be disposed to overlap with at least one or more light-emitting elements ED. Accordingly, the first opening hole BMO1 can define a light-emitting area in the display area AA. The second opening hole BMO2 may be disposed between the neighboring pixels PX and disposed to overlap with at least a portion of a plurality of communication wires NL.

On the second black matrix BM2 in the display area AA, there may be disposed a cover layer 118. For example, the cover layer 118 may be configured with an organic insulating material, but the embodiments of the present disclosure are not limited thereto. For example, the cover layer 118 may be configured with photoresist, polyimide, photo acryl-based material, or the like, but the embodiments of the present disclosure are not limited thereto. For example, the cover layer 118 may be an overcoating layer, an insulating layer, or the like. The cover layer 118 may be in direct contact with the second black matrix BM2. The cover layer 118 may also be in direct contact with the first black matrix BM1 in addition to the second black matrix BM2 because the polarizing layer is omitted.

On the cover layer 118 the cover member 155 may be disposed via the second adhesive layer 295. For example, the second adhesive layer 295 may include, but is not limited to, an optical adhesive (OCA), an optical resin (OCR), a pressure-sensitive adhesive (PSA), or the like.

One side of the cover layer 118 in the display area AA may be in contact with one side of the second adhesive layer 295. And the other side of the second adhesive layer 295 opposite to one side may be in contact with one side of the cover member 155.

As the second black matrix BM2 disposed in the upper side in the black matrix BM constructed in a multilayer structure reduces the reflectivity related to external light sources, the internal reflection by metal wirings or the like inside the display panel 100 can be reduced, thereby improving the visibility of the display device. Accordingly, the polarizing layer can be omitted from the display device. Thus, the display device lacks the polarizing layer.

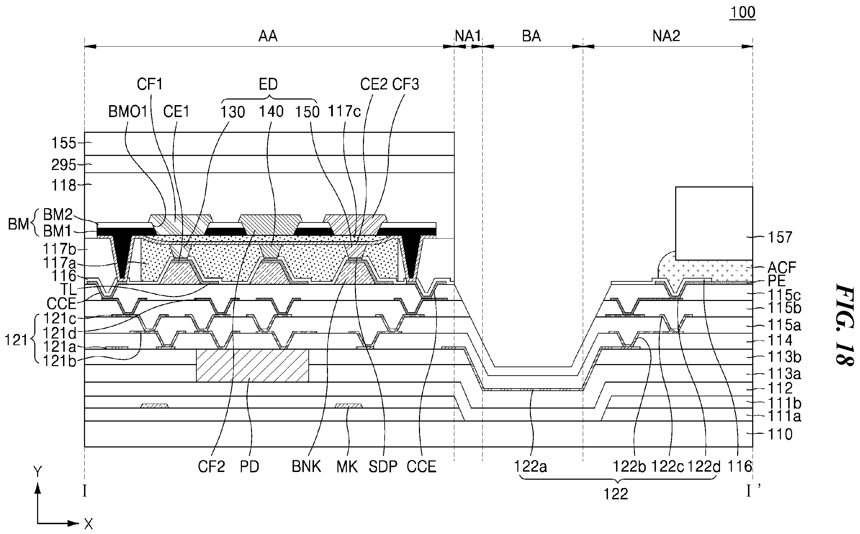

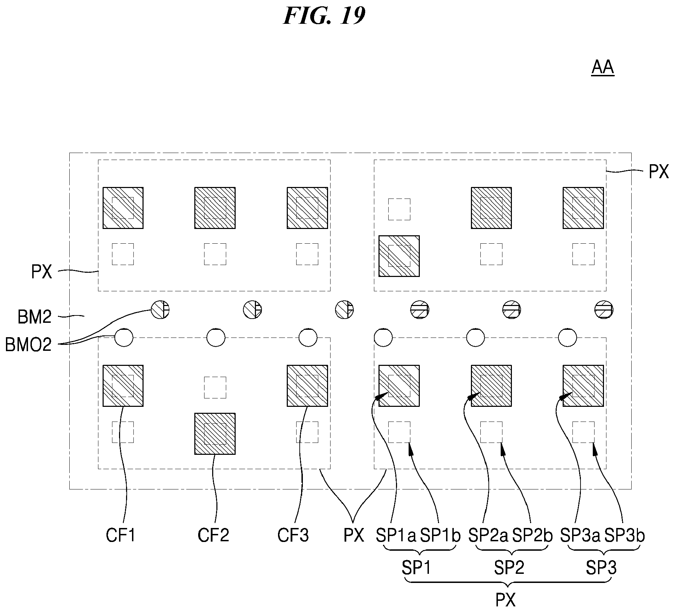

FIG. 18 is a cross-sectional view of a display device according to still another embodiment of the present disclosure. FIG. 19 is a plan view of a display device according to still another embodiment of the present disclosure.

In FIGS. 18 and 19, the same reference numerals will be given to the same components as those in FIG. 16 described with reference to FIG. 8, and the description thereof will be simplified or omitted.

Referring to FIGS. 18 and 19, a black matrix BM may be disposed on the second electrode CE2, the first optical layer 117a, the second optical layer 117b, and the third optical layer 117c in the display area AA.

The black matrix BM may include a first black matrix BM1 and a second black matrix BM2 on the first black matrix BM1, as described above. The first black matrix BM1 may be disposed between the sub-pixels SP1, SP2, SP3 in which a plurality of light-emitting elements ED are disposed, and between neighboring pixels PX.

The first black matrix BM1 may be an organic insulating material to which a black pigment or black dye capable of reducing light transmittance has been added. In an embodiment, the black pigment or black dye may include carbon black particles.

The film thickness of the first black matrix BM1 may be, for example, but not limited to, 1 micrometer (µm) or less. The first optical density O.D1 of the first black matrix BM1 may be greater than 3.0 and less than or equal to 4.0.

The second black matrix BM2 may be in contact with one side of the first black matrix BM1 and have at least the same area as the first black matrix BM1. The second black matrix BM2 may be configured with a translucent material. For example, the second black matrix BM2 may be an organic insulating material with black pigment or black dye added thereto. In an embodiment, the black pigment or black dye may include carbon black particles.

The second optical density O.D2 of the second black matrix BM2 may be smaller than the first optical density O.D1 of the first black matrix BM1. For example, the second optical density O.D2 of the second black matrix BM2 can be greater than 0 and less than or equal to 3.0 (0<O.D2≤3.0).

The black matrix BM may include a plurality of opening holes BMO1, BMO2. The plurality of opening holes BMO1, BMO2 may include a plurality of first opening holes BMO1 and a plurality of second opening holes BMO2. The first opening hole BMO1 may be disposed to correspond to each of the light-emitting elements ED on the first sub-pixel SP1, the second sub-pixel SP2, and the third sub-pixel SP3.

On the display area AA of the substrate 110 on which the black matrix BM is formed, there may be disposed a plurality of color filters CF1, CF2, CF3. The plurality of color filters CF1, CF2, CF3 may include a first color filter CF1, a second color filter CF2, and a third color filter CF3. The first color filter CF1 may be disposed on the first sub-pixel SP1. The second color filter CF2 may be disposed on the second sub-pixel SP2. The third color filter CF3 may be disposed on the third sub-pixel SP3. For example, one of the first color filter CF1, the second color filter CF2, and the third color filter CF3 may be a red filter, another thereof may be a green filter, and the remaining one thereof may be a blue filter; however, this is not exhaustive.

The first color filter CF1, the second color filter CF2, and the third color filter CF3 may be disposed to correspond to the first light-emitting element 130, the second light-emitting element 140, and the third light-emitting element 150, respectively.

Each of the first color filter CF1, the second color filter CF2, and the third color filter CF3 may fill the first opening hole BMO1. Each of the first color filter CF1, the second color filter CF2, and the third color filter CF3 may be extended to cover a portion of an edge of the upper surface of the second black matrix BM2. However, this is not exhaustive. For example, it may have the same vertical height as the upper surface of the second black matrix BM2.

Each of the first color filter CF1, the second color filter CF2, and the third color filter CF3 may be disposed to correspond to (e.g., overlap) one light-emitting element ED of a pair of light-emitting elements ED disposed in one sub-pixel, which has been determined to be normal and is exposed. For example, the first color filter CF1 may be disposed to correspond to the first light-emitting element 130 which has been determined to be normal, and the second color filter CF2 may be disposed to correspond to the second light-emitting element 140 which has been determined to be normal. And the third color filter CF3 may be disposed to correspond to the third light-emitting element 150 which has been determined to be normal.

Lights emitted from the first light-emitting element 130, the second light-emitting element 140, and the third light-emitting element 150 may be transmitted at a transmittance range of between 40% and 70% while passing through the first color filter CF1, the second color filter CF2, and the third color filter CF3. Accordingly, it is possible to prevent the brightness of light from decreasing in the entire display panel 100. As a result, power consumption for achieving the same brightness can be reduced.

On the second black matrix BM2, the first color filter CF1, the second color filter CF2, and the third color filter CF3, there may be disposed a cover layer 118. The cover layer 118 may include an organic insulating material. For example, the cover layer 118 may be configured with photo resist, polyimide, photo acryl-based material, or the like; however, this is not exhaustive.

On the cover layer 118 the cover member 155 may be disposed via the second adhesive layer 295. For example, the second adhesive layer 295 may include, but is not limited to, an optical adhesive (OCA), an optical resin (OCR), a pressure-sensitive adhesive (PSA), or the like.

One side of the cover layer 118 in the display area AA may be in contact with one side of the second adhesive layer 295. And the other side of the second adhesive layer 295 opposite to one side may be in contact with one side of the cover member 155. For example, one surface of the second adhesive layer 295 may be in contact with the upper surface of the cover layer 118, and the other surface of the second adhesive layer 295 may be in contact with the rear surface of the cover member 155. The rear side of the cover member 155 may be a side opposite to the front side that is visible to the user from the outside.

In still another embodiment of the present disclosure, the transmittance can be adjusted by omitting the polarizing layer and disposing a color filter. Accordingly, the light extraction efficiency of light emitted from the light-emitting element can be improved, thereby reducing power consumption. In addition, by constructing the second black matrix having a relatively lower optical density than that of the first black matrix, the reflectivity can be reduced, thereby allowing the polarizing layer to be omitted. In addition, by omitting the polarizing layer from the multilayer structure, a thin display device can be implemented, which can be applied to variable display devices such as foldable display devices.

The display device according to various embodiments of the present disclosure may be described as follows.

A display device according to an embodiment of the present disclosure may comprises: a substrate; a pixel driving circuit on the substrate; a plurality of light-emitting elements over the pixel driving circuit, the plurality of light-emitting elements electrically connected to the pixel driving circuit; an optical layer including at least one layer covering the plurality of light-emitting elements; a black matrix including at least one layer on the optical layer; a cover layer covering the black matrix; and a cover member on the cover layer

In one embodiment, the optical layer includes: a first optical layer covering side surfaces of the plurality of light-emitting elements; a second optical layer that surrounds a side surface of the first optical layer; and a third optical layer on an upper surface of the first optical layer.

In one embodiment, a black matrix includes: a first black matrix on the optical layer, the first black matrix having a first optical density; and a second black matrix on the first black matrix, the second black matrix having a second optical density that is different from the first optical density of the first black matrix.

In one embodiment, the second optical density of the second black matrix is less than the first optical density of the first black matrix.

In on embodiment, the first optical density of the first black matrix is greater than 3.0 at a thickness of 1 micrometer.

In one embodiment, the second optical density of the second black matrix is 3.0 or less at a thickness of 1 micrometer.

In one embodiment, the second black matrix includes an organic insulating material having carbon black particles that are dispersed in the organic insulating material.

In one embodiment, the display device further comprises: a plurality of color filters, each of the plurality of color filters associated with a different color, wherein the black matrix includes a plurality of opening holes that overlap with some of the plurality of light-emitting elements and the plurality of color filters overlap the plurality of opening holes.

In one embodiment, each of the plurality of color filters covers a portion of an edge of an upper surface of the black matrix.

In one embodiment, each of the plurality of color filters overlaps a corresponding one light-emitting element that is exposed by a corresponding opening hole from the plurality of opening holes.

In one embodiment, light emitted from a light-emitting element from the plurality of light-emitting elements passes through one of the plurality of color filters at a transmittance range between 40% and 70%.

In one embodiment, the display device further comprises: an adhesive layer between the cover layer and the cover member, wherein a first surface of the adhesive layer is in contact with an upper surface of the cover layer and a second surface of the adhesive layer is in contact with a rear surface of the cover member.

In one embodiment, the plurality of light-emitting elements includes a micro light-emitting element.

In one embodiment, the plurality of light-emitting elements includes a pair of light-emitting elements that emit light of a same color, and one light-emitting element from the pair is a main light-emitting element and another light-emitting element from the pair is a redundant light-emitting element.

In one embodiment, the pixel driving circuit includes a micro driver.

In one embodiment, an area of an opening hole from the plurality of opening holes is greater than an area of a light-emitting element from the plurality of light-emitting elements that is overlapped by the opening hole.

In one embodiment, the black matrix covers the main light-emitting element and an opening hole in the black matrix overlaps the redundant light-emitting element.

In one embodiment, the black matrix includes: a first black matrix on the optical layer, the first black matrix including an opaque material; and a second black matrix on the first black matrix, the second black matrix including a translucent material.

In one embodiment, the display device lacks a polarizing layer.

In one embodiment, each of the plurality of color filters fills a corresponding opening hole from the plurality of opening holes.

In one embodiment, a display device comprises: a substrate; a pixel driving circuit on the substrate; a plurality of light-emitting elements over the pixel driving circuit, the plurality of light-emitting elements electrically connected to the pixel driving circuit; a black matrix having a plurality of openings that overlap the plurality of light-emitting elements; a reflectivity reduction layer in direct contact with an upper surface of the black matrix, the reflectivity reduction layer configured to reduce reflection of external light; a cover layer covering the black matrix and the reflectivity reduction layer; and a cover member on the cover layer.

In one embodiment, the display device further comprises: an optical layer covering the plurality of light-emitting elements, the black matrix and the reflectivity reduction layer overlapping the optical layer.

In one embodiment, the optical layer includes: a first optical layer covering side surfaces of the plurality of light-emitting elements; a second optical layer that surrounds a side surface of the first optical layer; and a third optical layer on an upper surface of the first optical layer such that a portion of the third optical layer is between the black matrix and the first optical layer.

In one embodiment, the black matrix has a first optical density and the reflectivity reduction layer has a second optical density that is less than the first optical density of the black matrix.

In one embodiment, the black matrix includes an opaque material having black material dispersed in the opaque material and the reflectivity reduction layer includes a translucent material having black material dispersed in the opaque material.

In one embodiment, the display device further comprises: a plurality of color filters that fill the plurality of openings.

While the embodiments of the present disclosure have been described in detail with reference to the accompanying drawings, it should be understood by a person skilled in the art that the present disclosure is not necessarily limited to the above embodiments, and the above embodiments can be modified without departing from the technical idea of the present disclosure. Accordingly, the embodiments disclosed in the present disclosure are not intended to limit the technical idea of the present disclosure but to explain the technical idea of the present disclosure, and the scope of the technical idea of the present disclosure is not limited by these embodiments. Therefore, it should be understood that the embodiments described above are given only as an example in all respects but not for a limiting purpose.

The present disclosure also comprises examples according to the following numbered clauses.
1. A display device comprising:
   a substrate;
   a pixel driving circuit on the substrate;
   a plurality of light-emitting elements over the pixel driving circuit, the plurality of light-emitting elements electrically connected to the pixel driving circuit;
   an optical layer including at least one layer covering the plurality of light-emitting elements;
   a black matrix including at least one layer on the optical layer;
   a cover layer covering the black matrix; and
   a cover member on the cover layer.
2. The display device of clause 1, wherein the optical layer includes:
   a first optical layer covering side surfaces of the plurality of light-emitting elements;
   a second optical layer that surrounds a side surface of the first optical layer; and
   a third optical layer on an upper surface of the first optical layer.
3. The display device of clause 1 or clause 2, wherein the black matrix includes:
   a first black matrix on the optical layer, the first black matrix having a first optical density; and
   a second black matrix on the first black matrix, the second black matrix having a second optical density that is different from the first optical density of the first black matrix.
4. The display device of clause 3, wherein the second optical density of the second black matrix is less than the first optical density of the first black matrix.
5. The display device of clause 3 or clause 4, wherein the first optical density of the first black matrix is greater than 3.0 at a thickness of 1 micrometer.
6. The display device according to any of clauses 3 to 5, wherein the second optical density of the second black matrix is 3.0 or less at a thickness of 1 micrometer.
7. The display device according to any of clauses 3 to 6, wherein the second black matrix includes an organic insulating material having carbon black particles that are dispersed in the organic insulating material.
8. The display device of any preceding clause, further comprising:
   a plurality of color filters, each of the plurality of color filters associated with a different color,
   wherein the black matrix includes a plurality of opening holes that overlap with some of the plurality of light-emitting elements and the plurality of color filters overlap the plurality of opening holes.
9. The display device of clause 8, wherein each of the plurality of color filters covers a portion of an edge of an upper surface of the black matrix.
10. The display device of clause 8 or clause 9, wherein each of the plurality of color filters overlaps a corresponding one light-emitting element that is exposed by a corresponding opening hole from the plurality of opening holes.
11. The display device according to any of clauses 8 to 10, wherein light emitted from a light-emitting element from the plurality of light-emitting elements passes through one of the plurality of color filters at a transmittance range between 40% and 70%.
12. The display device of any preceding clause, further comprising:
   an adhesive layer between the cover layer and the cover member,
   wherein a first surface of the adhesive layer is in contact with an upper surface of the cover layer and a second surface of the adhesive layer is in contact with a rear surface of the cover member.
13. The display device of any preceding clause, wherein the plurality of light-emitting elements includes a micro light-emitting element.
14. The display device of any preceding clause, wherein the plurality of light-emitting elements includes a pair of light-emitting elements that emit light of a same color, and
   wherein one light-emitting element from the pair is a main light-emitting element and another light-emitting element from the pair is a redundant light-emitting element.
15. The display device of any preceding clause, wherein the pixel driving circuit includes a micro driver.
16. The display device of clause 8, wherein an area of an opening hole from the plurality of opening holes is greater than an area of a light-emitting element from the plurality of light-emitting elements that is overlapped by the opening hole.
17. The display device of clause 14, wherein the black matrix covers the main light-emitting element and an opening hole in the black matrix overlaps the redundant light-emitting element.
18. The display device of any preceding clause, wherein the black matrix includes:
   a first black matrix on the optical layer, the first black matrix including an opaque material; and
   a second black matrix on the first black matrix, the second black matrix including a translucent material.
19. The display device of any preceding clause, wherein the display device lacks a polarizing layer.
20. The display device of clause 8, wherein each of the plurality of color filters fills a corresponding opening hole from the plurality of opening holes.
21. A display device comprising:
   a substrate;
   a pixel driving circuit on the substrate;
   a plurality of light-emitting elements over the pixel driving circuit, the plurality of light-emitting elements electrically connected to the pixel driving circuit;
   a black matrix having a plurality of openings that overlap the plurality of light-emitting elements;
   a reflectivity reduction layer in direct contact with an upper surface of the black matrix, the reflectivity reduction layer configured to reduce reflection of external light;
   a cover layer covering the black matrix and the reflectivity reduction layer; and
   a cover member on the cover layer.
22. The display device of clause 21, further comprising:
   an optical layer covering the plurality of light-emitting elements, the black matrix and the reflectivity reduction layer overlapping the optical layer.
23. The display device of clause 22, wherein the optical layer includes:
   a first optical layer covering side surfaces of the plurality of light-emitting elements;
   a second optical layer that surrounds a side surface of the first optical layer; and
   a third optical layer on an upper surface of the first optical layer such that a portion of the third optical layer is between the black matrix and the first optical layer.
24. The display device according to any of clauses 21 to 23, wherein the black matrix has a first optical density and the reflectivity reduction layer has a second optical density that is less than the first optical density of the black matrix.
25. The display device according to any of clauses 21 to 24, wherein the black matrix includes an opaque material having black material dispersed in the opaque material and the reflectivity reduction layer includes a translucent material having black material dispersed in the opaque material.
26. The display device according to any of clauses 21 to 25, further comprising:
   a plurality of color filters that fill the plurality of openings.

## Claims

1. A display device comprising:
a substrate;
a pixel driving circuit on the substrate;
a plurality of light-emitting elements over the pixel driving circuit, the plurality of light-emitting elements electrically connected to the pixel driving circuit;
an optical layer including at least one layer covering the plurality of light-emitting elements;
a black matrix including at least one layer on the optical layer;
a cover layer covering the black matrix; and
a cover member on the cover layer.

2. The display device of claim 1, wherein the optical layer includes:
a first optical layer covering side surfaces of the plurality of light-emitting elements;
a second optical layer that surrounds a side surface of the first optical layer; and
a third optical layer on an upper surface of the first optical layer.

3. The display device of claim 1 or claim 2, wherein the black matrix includes:
a first black matrix on the optical layer, the first black matrix having a first optical density; and
a second black matrix on the first black matrix, the second black matrix having a second optical density that is different from the first optical density of the first black matrix.

4. The display device of claim 3, wherein the second optical density of the second black matrix is less than the first optical density of the first black matrix.

5. The display device of claim 3 or claim 4, wherein the first optical density of the first black matrix is greater than 3.0 at a thickness of 1 micrometer, and/or wherein the second optical density of the second black matrix is 3.0 or less at a thickness of 1 micrometer.

6. The display device according to any of claims 3 to 5, wherein the second black matrix includes an organic insulating material having carbon black particles that are dispersed in the organic insulating material.

7. The display device of any preceding claim, further comprising:
a plurality of color filters, each of the plurality of color filters associated with a different color,
wherein the black matrix includes a plurality of opening holes that overlap with some of the plurality of light-emitting elements and the plurality of color filters overlap the plurality of opening holes, and optionally:
wherein each of the plurality of color filters fills a corresponding opening hole from the plurality of opening holes and/or wherein an area of an opening hole from the plurality of opening holes is greater than an area of a light-emitting element from the plurality of light-emitting elements that is overlapped by the opening hole.

8. The display device of claim 7, wherein each of the plurality of color filters covers a portion of an edge of an upper surface of the black matrix.

9. The display device of claim 7 or claim 8, wherein each of the plurality of color filters overlaps a corresponding one light-emitting element that is exposed by a corresponding opening hole from the plurality of opening holes, and/or wherein light emitted from a light-emitting element from the plurality of light-emitting elements passes through one of the plurality of color filters at a transmittance range between 40% and 70%.

10. The display device of any preceding claim, further comprising:
an adhesive layer between the cover layer and the cover member,
wherein a first surface of the adhesive layer is in contact with an upper surface of the cover layer and a second surface of the adhesive layer is in contact with a rear surface of the cover member.

11. The display device of any preceding claim, wherein the plurality of light-emitting elements includes a micro light-emitting element.

12. The display device of any preceding claim, wherein the plurality of light-emitting elements includes a pair of light-emitting elements that emit light of a same color, and
wherein one light-emitting element from the pair is a main light-emitting element and another light-emitting element from the pair is a redundant light-emitting element,
and optionally wherein the black matrix covers the main light-emitting element and an opening hole in the black matrix overlaps the redundant light-emitting element.

13. The display device of any preceding claim, wherein the pixel driving circuit includes a micro driver.

14. The display device of claim 1, wherein the black matrix includes:
a first black matrix on the optical layer, the first black matrix including an opaque material; and
a second black matrix on the first black matrix, the second black matrix including a translucent material.

15. The display device of any preceding claim, wherein the display device lacks a polarizing layer.
